# EUROPEAN PATENT APPLICATION

(11) **EP 4 658 025 A1**
(43) Date of publication of application: **03.12.2025**
(21) Application number: 25178013.6
(22) Date of filing: 21.05.2025
(51) Int. Cl.: H10F 10/14, H10F 10/165, H10F 77/20, H10F 77/30

(54) **SEMICONDUCTOR STRUCTURE, SOLAR CELL AND MANUFACTURING METHOD THEREOF, AND PHOTOVOLTAIC MODULE**

(30) Priority: 30.05.2024 CN 202410684958
(71) Applicant: LONGi Green Energy Technology Co., Ltd., Xi'an, Shaanxi 710100 (CN)
(72) Inventor: ZHANG, Boyue, Xi'an, 710100 (CN); ZHAO, Xueliang, Xi'an, 710100 (CN); CHEN, Yao, Xi'an, 710100 (CN); ZHANG, Yue, Xi'an, 710100 (CN); TONG, Hongbo, Xi'an, 710100 (CN)
(74) Representative: Pfenning, Meinig & Partner mbB

(57) **Abstract**

The present application discloses a semiconductor structure, a solar cell and a manufacturing method thereof, and a photovoltaic module, which relates to the field of photovoltaic technologies and is configured to improve the operating performance of the solar cell. The solar cell includes a semiconductor substrate, a P-type doped polysilicon layer, and an N-type doped polysilicon layer. The semiconductor substrate includes a first region and a second region. The P-type doped polysilicon layer is formed at least on the first region. The N-type doped polysilicon layer is formed at least on the second region. At least a portion of the N-type doped polysilicon layer is spaced apart from at least a portion of the P-type doped polysilicon layer. A ratio of a refractive index n of the N-type doped polysilicon layer to a refractive index n of the P-type doped polysilicon layer is greater than or equal to 0.9 and less than or equal to 1.1; and/or an absolute value of a difference value between the refractive index n of the P-type doped polysilicon layer and the refractive index n of the N-type doped polysilicon layer is greater than or equal to 0 and less than or equal to 0.1.

## Description

### TECHNICAL FIELD

The present application relates to the field of photovoltaic technologies, and in particular, to a semiconductor structure, a solar cell and a manufacturing method thereof, and a photovoltaic module.

### BACKGROUND

A solar cell is an apparatus that can convert solar energy into electric energy. Specifically, when the solar cell is in an operating state, sunlight irradiates onto a semiconductor p-n junction of the solar cell to form new hole-electron pairs. Under an action of a built-in electric field of the p-n junction, photogenerated holes flow to a p-type region, and photogenerated electrons flow to an n-type region, so that a current can be generated when a circuit is powered on.

However, in existing solar cells, there is a difference between light refraction effects of an N-type doped polysilicon layer and a P-type doped polysilicon layer, making it difficult to ensure balance between electrons and holes, which is not conducive to improving the operating efficiency of the solar cells.

### SUMMARY

An objective of the present application is to provide a semiconductor structure, a solar cell and a manufacturing method thereof, and a photovoltaic module, so that light refraction effects of an N-type doped polysilicon layer and a P-type doped polysilicon layer are approximately the same, which is conducive to ensuring balance between electrons and holes, and improving the operating efficiency of the solar cell.

To achieve the foregoing objective, according to a first aspect, the present application provides a solar cell. The solar cell includes: a semiconductor substrate, a P-type doped polysilicon layer, and an N-type doped polysilicon layer. The semiconductor substrate includes a first region and a second region. The first region and the second region are located on the same surface of the semiconductor substrate, or the first region and the second region are respectively located on two opposite surfaces of the semiconductor substrate. The P-type doped polysilicon layer is formed at least on the first region. The N-type doped polysilicon layer is formed at least on the second region. At least a portion of the N-type doped polysilicon layer is spaced apart from at least a portion of the P-type doped polysilicon layer. A ratio of a refractive index n of the N-type doped polysilicon layer to a refractive index n of the P-type doped polysilicon layer is greater than or equal to 0.9 and less than or equal to 1.1; and/or an absolute value of a difference value between the refractive index n of the P-type doped polysilicon layer and the refractive index n of the N-type doped polysilicon layer is greater than or equal to 0 and less than or equal to 0.1.

In a case that the foregoing technical solution is used, one of the P-type doped polysilicon layer and the N-type doped polysilicon layer may form a high-low junction with the semiconductor substrate, and the other may form a PN junction with the semiconductor substrate. Based on this, when the solar cell is in an operating state, after the semiconductor substrate absorbs photons, new hole-electron pairs may be formed. Under an action of built-in electric fields of the PN junction and the high-low junction, photogenerated holes flow to the P-type doped polysilicon layer, and photogenerated electrons flow to the N-type doped polysilicon layer, so that a current can be generated after a circuit is powered on. Besides, in addition to respectively collecting and transmitting electrons and holes generated in the semiconductor substrate, the N-type doped polysilicon layer and the P-type doped polysilicon layer can also generate some electron-hole pairs after absorbing photons to generate electricity. In addition, after light enters the semiconductor substrate from a side of the semiconductor substrate corresponding to a light receiving surface of the solar cell, a part of the light runs through the semiconductor substrate and reaches an interface between the semiconductor substrate and the N-type doped polysilicon layer or an interface between the semiconductor substrate and the P-type doped polysilicon layer. In this case, the N-type doped polysilicon layer and the P-type doped polysilicon layer may reflect the part of light, so that the semiconductor substrate absorbs light energy twice, and more electron-hole pairs are generated, thereby improving the light utilization of the semiconductor substrate. In the foregoing case, when the ratio of the refractive index n of the N-type doped polysilicon layer to the refractive index n of the P-type doped polysilicon layer falls within the foregoing range, the refractive indexes n of the N-type doped polysilicon layer and the P-type doped polysilicon layer are approximately equal, so that light refraction effects of the N-type doped polysilicon layer and the P-type doped polysilicon layer are approximately the same, which is conducive to ensuring balance between electrons and holes, thereby improving the operating efficiency of the solar cell. In addition, the absolute value of the difference value between the refractive index n of the P-type doped polysilicon layer and the refractive index n of the N-type doped polysilicon layer is greater than or equal to 0 and less than or equal to 0.1. For beneficial effects in this case, reference may be made to the beneficial effects when the ratio of the refractive index n of the N-type doped polysilicon layer to the refractive index n of the P-type doped polysilicon layer is greater than or equal to 0.9 and less than or equal to 1.1 described above, and details are not described herein.

In a possible implementation, an extinction coefficient k of the N-type doped polysilicon layer is greater than an extinction coefficient k of the P-type doped polysilicon layer.

In a case that the foregoing technical solution is used, since conductivity types of carriers to be collected by the P-type doped polysilicon layer and the N-type doped polysilicon layer are different, compositions of an electrode slurry for manufacturing positive electrodes electrically connected to the P-type doped polysilicon layer and an electrode slurry for manufacturing negative electrodes electrically connected to the N-type doped polysilicon layer are correspondingly different, to ensure that the positive electrodes have a relatively high hole transmission rate and ensure that the negative electrodes have a relatively high electron transmission rate. Positive electrodes and negative electrodes that have different slurry compositions have different film layer etching capabilities, an etching depth of the positive electrodes is far greater than that of the negative electrodes for film layers with the same density, and the positive electrodes have a greater burn-through risk. By adjusting a density of the P-type doped polysilicon layer and a density of the N-type doped polysilicon layer, the P-type doped polysilicon layer is denser, and etching resistance to the positive electrodes is increased, so that the etching depth of the positive electrodes is reduced, and the positive electrodes stay at a suitable depth. The extinction coefficient k of the N-type doped polysilicon layer and the extinction coefficient k of the P-type doped polysilicon layer are related to the film layer densities of the N-type doped polysilicon layer and the P-type doped polysilicon layer. Within a specific range, the extinction coefficient k of the N-type doped polysilicon layer and the extinction coefficient k of the P-type doped polysilicon layer are inversely proportional to the film layer densities of the N-type doped polysilicon layer and the P-type doped polysilicon layer. Based on this, the film layer densities of the N-type doped polysilicon layer and the P-type doped polysilicon layer may be regulated by adjusting a magnitude relationship between the extinction coefficients k of the two film layers. By setting the extinction coefficient k of the N-type doped polysilicon layer to be greater than the extinction coefficient k of the P-type doped polysilicon layer, the P-type doped polysilicon layer has a relatively high density, and the P-type doped polysilicon layer has a relatively high capability against etching by the electrode slurry, so that the manufactured positive electrodes are prevented from penetrating the P-type doped polysilicon layer. Therefore, a matching degree between the P-type doped polysilicon layer and the electrode slurry corresponding to the positive electrodes is improved, and it is ensured that the P-type doped polysilicon layer has a relatively high field passivation effect, thereby reducing a carrier recombination rate on a back surface, and improving the operating performance of the solar cell.

**In** a possible implementation, the solar cell further includes a surface passivation layer. The surface passivation layer at least covers a side of the P-type doped polysilicon layer facing away from the semiconductor substrate and a side of the N-type doped polysilicon layer facing away from the semiconductor substrate. A ratio of an extinction coefficient k of the N-type doped polysilicon layer to an extinction coefficient k of the P-type doped polysilicon layer is greater than or equal to 1.5 and less than or equal to 2.5; and/or a difference value between the extinction coefficient k of the N-type doped polysilicon layer and the extinction coefficient k of the P-type doped polysilicon layer is greater than or equal to 0.2 and less than or equal to 0.5.

In a case that the foregoing technical solution is used, the ratio of the extinction coefficient k of the N-type doped polysilicon layer to the extinction coefficient k of the P-type doped polysilicon layer falls within the foregoing range, so that a case that the negative electrodes easily penetrate the N-type doped polysilicon layer caused by an excessively loose film layer of the N-type doped polysilicon layer due to a large ratio is prevented, thereby ensuring that the N-type doped polysilicon layer has a relatively high field passivation effect. In addition, in a case that the first region and the second region are located on the same surface or the first region is located in a portion of a surface, large etching difficulty and low etching efficiency during patterning treatment on the P-type doped polysilicon layer deposited as a whole caused by an excessively dense film layer of the P-type doped polysilicon layer due to the large ratio may be further prevented, so that difficulty in manufacturing the solar cell is reduced and the manufacturing efficiency of the solar cell is improved. In addition, a small contact area between the formed positive electrodes and the P-type doped polysilicon layer caused by the excessively dense P-type doped polysilicon layer may be further prevented, thereby ensuring small contact resistance between the positive electrodes and the negative electrodes. In addition, the ratio of the extinction coefficient k of the N-type doped polysilicon layer to the extinction coefficient k of the P-type doped polysilicon layer falls within the foregoing range, so that a small improvement degree of the density of the P-type doped polysilicon layer due to a small ratio may be further prevented, which is conducive to reducing a metal recombination loss between the positive electrodes and the P-type doped polysilicon layer while ensuring that the positive electrodes do not penetrate the P-type doped polysilicon layer, thereby ensuring that the solar cell has relatively high operating performance.

In a possible implementation, the solar cell further includes positive electrodes that are in ohmic contact with the P-type doped polysilicon layer and negative electrodes that are in ohmic contact with the N-type doped polysilicon layer. In addition, along a thickness direction of the semiconductor substrate, a depth by which at least a part of the positive electrodes extend into the P-type doped polysilicon layer is greater than or equal to a depth by which at least a part of the negative electrodes extend into the N-type doped polysilicon layer. In this scenario, when the depth by which at least a part of the positive electrodes extend into the P-type doped polysilicon layer is greater than or equal to the depth by which at least a part of the negative electrodes extend into the N-type doped polysilicon layer, it helps increase the contact area between the positive electrodes and the P-type doped polysilicon layer. This, in turn, reduces contact resistance between the positive electrodes and the P-type doped polysilicon layer, which is conducive to reducing a transmission loss during transmission of holes from the P-type doped polysilicon layer to the positive electrodes, thereby improving the operating performance of the solar cell. In addition, in an actual application process, due to factors such as a limitation of a doping solid concentration, a doping concentration of impurities in the P-type doped polysilicon layer is generally less than a doping concentration of impurities in the N-type doped polysilicon layer, so that when the depth by which at least a part of the positive electrodes extend into the P-type doped polysilicon layer is greater than or equal to the depth by which the at least a part of the negative electrodes extend into the N-type doped polysilicon layer, a large metal recombination area between the N-type doped polysilicon layer and the negative electrodes caused by a large contact area between the N-type doped polysilicon layer and the negative electrodes is further prevented, thereby ensuring a small recombination loss between the N-type doped polysilicon layer and the negative electrodes.

In a possible implementation, in a case that the solar cell further includes the positive electrodes that are in ohmic contact with the P-type doped polysilicon layer and the negative electrodes that are in ohmic contact with the N-type doped polysilicon layer, along a thickness direction of the semiconductor substrate, a depth by which at least a part of the positive electrodes extend into the P-type doped polysilicon layer is greater than or equal to 80 nm and less than or equal to 100 nm.

In a case that the foregoing technical solution is used, along the thickness direction of the semiconductor substrate, the depth by which at least a part of the positive electrodes extend into the P-type doped polysilicon layer falls within the foregoing range, which is conducive to preventing a small contact area between the positive electrodes and the P-type doped polysilicon layer caused by a small depth and is conducive to reducing contact resistance between the positive electrodes and the P-type doped polysilicon layer. In addition, this is also conducive to preventing an excessively large contact area between the positive electrodes and the P-type doped polysilicon layer caused by a large depth and is conducive to reducing a metal recombination loss between the positive electrodes and the P-type doped polysilicon layer. Based on the above, the depth by which the positive electrodes extend into the P-type doped polysilicon layer falls within the foregoing range, which is conducive to balancing the contact resistance and the metal recombination loss between the positive electrodes and the P-type doped polysilicon layer, thereby ensuring that the solar cell has relatively high operating performance.

In a possible implementation, in a case that the solar cell further includes the positive electrodes that are in ohmic contact with the P-type doped polysilicon layer and the negative electrodes that are in ohmic contact with the N-type doped polysilicon layer, along a thickness direction of the semiconductor substrate, a depth by which at least a part of the negative electrodes extend into the N-type doped polysilicon layer is greater than or equal to 50 nm and less than or equal to 80 nm. Beneficial effects in this case are similar to the beneficial effects of the case that the depth by which at least a part of the positive electrodes extend into the P-type doped polysilicon layer is greater than or equal to 80 nm and less than or equal to 100 nm described above, and details are not described herein.

In a possible implementation, the solar cell further includes a first tunneling passivation layer, and the first tunneling passivation layer is located between the P-type doped polysilicon layer and the semiconductor substrate.

In a case that the foregoing technical solution is used, the first tunneling passivation layer and the P-type doped polysilicon layer may form a tunneling passivation contact structure, to perform chemical passivation on the first region of the semiconductor substrate and selectively collect holes, so that a carrier recombination rate on a side of the semiconductor substrate on which the first tunneling passivation layer is formed is reduced, which is conducive to improving the photoelectric conversion efficiency of the solar cell.

In a possible implementation, the solar cell further includes a second tunneling passivation layer, and the second tunneling passivation layer is at least located between the N-type doped polysilicon layer and the semiconductor substrate.

In a case that the foregoing technical solution is used, the second tunneling passivation layer and the N-type doped polysilicon layer may form a tunneling passivation contact structure, to perform chemical passivation on the second region of the semiconductor substrate and selectively collect electrons, so that a carrier recombination rate on a side of the semiconductor substrate on which the second tunneling passivation layer is formed is reduced, which is conducive to improving the photoelectric conversion efficiency of the solar cell.

In a possible implementation, the solar cell is a back contact solar cell. In this case, the first region and the second region are located on the same surface of the semiconductor substrate. Compared with a double-sided contact solar cell, the technical solutions of the present application have a higher application advantage on the back contact solar cell, in the technology of the present application, a height difference between two regions of the back contact solar cell can be used and effectively controlled, so that an interconnection yield is improved; and patterning efficiency is improved, and production efficiency is improved.

According to a second aspect, the present application provides a semiconductor structure. The semiconductor structure includes: a semiconductor substrate, a P-type doped polysilicon layer, and an N-type doped polysilicon layer. The semiconductor substrate includes a first region and a second region. The first region and the second region are located on the same surface of the semiconductor substrate, or the first region and the second region are respectively located on two opposite surfaces of the semiconductor substrate. The P-type doped polysilicon layer is formed at least on the first region. The N-type doped polysilicon layer is formed at least on the second region. At least a portion of the N-type doped polysilicon layer is spaced apart from at least a portion of the P-type doped polysilicon layer. A ratio of a refractive index n of the N-type doped polysilicon layer to a refractive index n of the P-type doped polysilicon layer is greater than or equal to 0.8 and less than or equal to 1.2; and/or an absolute value of a difference value between the refractive index n of the P-type doped polysilicon layer and the refractive index n of the N-type doped polysilicon layer is greater than or equal to 0 and less than or equal to 0.2.

In a case that the foregoing technical solution is used, in a solar cell manufactured based on the semiconductor structure provided in the present application, the refractive index n of the N-type doped polysilicon layer and the refractive index n of the P-type doped polysilicon layer are approximately equal. For beneficial effects when the refractive index n of the N-type doped polysilicon layer and the refractive index n of the P-type doped polysilicon layer in the solar cell are approximately equal, reference may be made to the foregoing description, and details are not described herein.

In a possible implementation, a ratio of an extinction coefficient k of the N-type doped polysilicon layer to an extinction coefficient k of the P-type doped polysilicon layer is greater than 1 and less than or equal to 2.6; and/or a difference value between the extinction coefficient k of the N-type doped polysilicon layer and the extinction coefficient k of the P-type doped polysilicon layer is greater than 0 and less than or equal to 0.2.

In a case that the foregoing technical solution is used, it may be understood that, the semiconductor structure provided in the present application is configured for manufacturing an intermediate state structure or a semi-finished product of a solar cell. Based on this, when the ratio of the extinction coefficient k of the N-type doped polysilicon layer to the extinction coefficient k of the P-type doped polysilicon layer in the semiconductor structure provided in the present application is greater than 1 and less than or equal to 2.6, the extinction coefficient k of the N-type doped polysilicon layer is greater than the extinction coefficient k of the P-type doped polysilicon layer, so that the extinction coefficient k of the N-type doped polysilicon layer is also greater than the extinction coefficient k of the P-type doped polysilicon layer in the solar cell manufactured based on the semiconductor structure provided in the present application. For beneficial effects when the extinction coefficient k of the N-type doped polysilicon layer is also greater than the extinction coefficient k of the P-type doped polysilicon layer in the solar cell, reference may be made to the foregoing description, and details are not described herein. Similarly, for beneficial effects when the difference value between the extinction coefficient k of the N-type doped polysilicon layer and the extinction coefficient k of the P-type doped polysilicon layer is greater than 0 and less than or equal to 0.2, reference may be made to the analysis of the beneficial effects when the extinction coefficient k of the N-type doped polysilicon layer is also greater than the extinction coefficient k of the P-type doped polysilicon layer in the solar cell described above.

According to a third aspect, the present application provides a manufacturing method of a solar cell. The manufacturing method of a solar cell includes: providing a semiconductor substrate, where the semiconductor substrate includes a first region and a second region; and the first region and the second region are located on the same surface of the semiconductor substrate, or the first region and the second region are respectively located on two opposite surfaces of the semiconductor substrate; forming a P-type doped polysilicon layer at least on the first region; and forming an N-type doped polysilicon layer at least on the second region, where at least a portion of the N-type doped polysilicon layer is spaced apart from at least a portion of the P-type doped polysilicon layer; a ratio of a refractive index n of the N-type doped polysilicon layer to a refractive index n of the P-type doped polysilicon layer is greater than or equal to 0.9 and less than or equal to 1.1; and/or an absolute value of a difference value between the refractive index n of the P-type doped polysilicon layer and the refractive index n of the N-type doped polysilicon layer is greater than or equal to 0 and less than or equal to 0.1.

For beneficial effects of the third aspect of the present application, reference may be made to the analysis of the beneficial effects of the first aspect and various implements of the first aspect, and details are not described herein.

In a possible implementation, in a case that the first region and the second region are located on the same surface of the semiconductor substrate, the forming a P-type doped polysilicon layer at least on the first region includes: forming a first intrinsic polysilicon layer covering the first region and the second region; performing diffusion treatment on the first intrinsic polysilicon layer, to form the first intrinsic polysilicon layer into the P-type doped polysilicon layer; and selectively removing a part of the P-type doped polysilicon layer located on at least a part of the second region; and the forming an N-type doped polysilicon layer at least on the second region includes: forming a second intrinsic polysilicon layer at least covering the P-type doped polysilicon layer and the second region; performing diffusion treatment on the second intrinsic polysilicon layer, to form the second intrinsic polysilicon layer into the N-type doped polysilicon layer; and selectively removing a part of the N-type doped polysilicon layer located on at least a part of the P-type doped polysilicon layer; or
the forming an N-type doped polysilicon layer at least on the second region includes: forming a second intrinsic polysilicon layer covering the first region and the second region; performing diffusion treatment on the second intrinsic polysilicon layer, to form the second intrinsic polysilicon layer into the N-type doped polysilicon layer; and selectively removing a part of the N-type doped polysilicon layer located on at least a part of the first region; and the forming a P-type doped polysilicon layer at least on the first region includes: forming a first intrinsic polysilicon layer at least covering the N-type doped polysilicon layer and the first region; performing diffusion treatment on the first intrinsic polysilicon layer, to form the first intrinsic polysilicon layer into the P-type doped polysilicon layer; and selectively removing a part of the P-type doped polysilicon layer located on at least a part of the N-type doped polysilicon layer.

In a possible implementation, in a case that the first region and the second region are respectively located on two opposite surfaces of the semiconductor substrate, the forming a P-type doped polysilicon layer at least on the first region includes: forming a first intrinsic polysilicon layer at least covering the first region; and performing diffusion treatment on the first intrinsic polysilicon layer, to form the first intrinsic polysilicon layer into the P-type doped polysilicon layer; and the forming an N-type doped polysilicon layer at least on the second region includes: forming a second intrinsic polysilicon layer at least covering the second region; and performing diffusion treatment on the second intrinsic polysilicon layer, to form the second intrinsic polysilicon layer into the N-type doped polysilicon layer.

In a possible implementation, an extinction coefficient k of the first intrinsic polysilicon layer is less than an extinction coefficient k of the P-type doped polysilicon layer. In this case, a density of the first intrinsic polysilicon layer is higher than that of the P-type doped polysilicon layer, which is conducive to preventing a problem of extending through or a large internal extension range since impurities pass through the first intrinsic polysilicon layer and enter the semiconductor substrate when diffusion treatment is performed on the first intrinsic polysilicon layer, thereby ensuring that the solar cell has a high open-circuit voltage and fill factor.

In a possible implementation, a refractive index n of the first intrinsic polysilicon layer is greater than or equal to a refractive index n of the P-type doped polysilicon layer.

In a case that the foregoing technical solution is used, the refractive index n of the first intrinsic polysilicon layer and the refractive index n of the P-type doped polysilicon layer are related to the densities of the film layers. Within a specific range, the refractive index n of the first intrinsic polysilicon layer and the refractive index n of the P-type doped polysilicon layer are positively proportional to the densities of the film layers. Based on this, when the refractive index n of the first intrinsic polysilicon layer is greater than or equal to the refractive index n of the P-type doped polysilicon layer, the first intrinsic polysilicon layer is relatively dense, which is conducive to preventing a problem of extending through or a large internal extension range since impurities pass through the first intrinsic polysilicon layer and enter the semiconductor substrate when diffusion treatment is performed on the first intrinsic polysilicon layer, thereby ensuring that the solar cell has a high open-circuit voltage and fill factor.

In a possible implementation, a refractive index n of the second intrinsic polysilicon layer is less than a refractive index n of the N-type doped polysilicon layer.

In a case that the foregoing technical solution is used, the refractive index n of the second intrinsic polysilicon layer and the refractive index n of the N-type doped polysilicon layer are also related to densities of the film layers. Within a specific range, the refractive index n of the second intrinsic polysilicon layer and the refractive index n of the N-type doped polysilicon layer are positively proportional to the densities of the film layers. In this case, when the refractive index n of the second intrinsic polysilicon layer is less than the refractive index n of the N-type doped polysilicon layer, before the diffusion treatment, the second intrinsic polysilicon layer has a relatively low density, which is conducive to doping N-type impurities into the second intrinsic polysilicon layer. After the diffusion treatment, the density of the N-type doped polysilicon layer is increased, which is conducive to preventing the electrode slurry for manufacturing the negative electrodes from penetrating the N-type doped polysilicon layer and reducing a metal recombination area between the N-type doped polysilicon layer and the negative electrodes, thereby reducing a metal recombination loss.

In a possible implementation, an extinction coefficient k of the second intrinsic polysilicon layer is greater than an extinction coefficient k of the N-type doped polysilicon layer. In this case, as described above, within a specific range, the extinction coefficient k of the film layer is inversely proportional to the density of the film layer. Based on this, when the extinction coefficient k of the second intrinsic polysilicon layer is greater than the extinction coefficient k of the N-type doped polysilicon layer, the density of the second intrinsic polysilicon layer is lower than the density of the N-type doped polysilicon layer. For beneficial effects when the density of the second intrinsic polysilicon layer is lower than the density of the N-type doped polysilicon layer, reference may be made to the foregoing description, and details are not described herein.

In a possible implementation, a thickness of the second intrinsic polysilicon layer is less than a thickness of the first intrinsic polysilicon layer.

In a case that the foregoing technical solution is used, as described above, a film layer etching capability of the electrode slurry for manufacturing the positive electrodes is greater than a film layer etching capability of the electrode slurry for manufacturing the negative electrodes. The first intrinsic polysilicon layer is configured for manufacturing the P-type doped polysilicon layer, and the second intrinsic polysilicon layer is configured for manufacturing the N-type doped polysilicon layer. In the foregoing case, when the thickness of the second intrinsic polysilicon layer is less than the thickness of the first intrinsic polysilicon layer, a thickness of the P-type doped polysilicon layer formed based on the first intrinsic polysilicon layer with a greater thickness is increased, so that a risk that the electrode slurry for manufacturing the positive electrodes penetrates the P-type doped polysilicon layer is further reduced, thereby ensuring that the P-type doped polysilicon layer has a relatively high field passivation effect and preventing the electrode slurry for manufacturing the positive electrodes from causing damage to the semiconductor substrate.

In a possible implementation, a ratio of the thickness of the second intrinsic polysilicon layer to the thickness of the first intrinsic polysilicon layer is greater than or equal to 0.55 and less than or equal to 0.8; and/or a difference value between the thickness of the second intrinsic polysilicon layer and the thickness of the first intrinsic polysilicon layer is greater than or equal to -140 nm and less than or equal to -100 nm.

**In** a case that the foregoing technical solution is used, the ratio of the thickness of the second intrinsic polysilicon layer to the thickness of the first intrinsic polysilicon layer falls within the foregoing range, so that a small thickness of the second intrinsic polysilicon layer and/or a large thickness of the first intrinsic polysilicon layer caused by a small ratio may be prevented; and a large thickness of the second intrinsic polysilicon layer and/or a small thickness of the first intrinsic polysilicon layer caused by a large ratio may also be prevented. Based on the above, the ratio of the thickness of the second intrinsic polysilicon layer to the thickness of the first intrinsic polysilicon layer falls within the foregoing range, which is conducive to properly setting the thickness of the first intrinsic polysilicon layer and the thickness of the second intrinsic polysilicon layer, thereby ensuring that problems such as extending through or a large internal extension range do not occur after the diffusion treatment. In addition, the P-type doped polysilicon layer and the N-type doped polysilicon layer respectively have a high matching degree with the electrode slurry for manufacturing the positive electrodes and the electrode slurry for manufacturing the negative electrodes, thereby ensuring that the P-type doped polysilicon layer and the N-type doped polysilicon layer each have a relatively high field passivation effect.

In a possible implementation, a refractive index n of the second intrinsic polysilicon layer is less than a refractive index n of the first intrinsic polysilicon layer.

In a case that the foregoing technical solution is used, as described above, within a specific range, the refractive index n of the film layer is positively proportional to the density of the film layer. Based on this, when the refractive index n of the second intrinsic polysilicon layer is less than the refractive index n of the first intrinsic polysilicon layer, the first intrinsic polysilicon layer has a relatively high film layer density, which is conducive to preventing P-type impurities such as boron atoms with a small size from extending through the first intrinsic polysilicon layer. In addition, N-type impurities such as phosphorus with a large size are doped into the second intrinsic polysilicon layer in a substitutional diffusion manner. In the substitutional diffusion manner, semiconductor atoms are replaced with impurity atoms to form a doped region, so that when the density of the second intrinsic polysilicon layer is relatively low, diffusion of the N-type impurities such as phosphorus with a large size is implemented, and the diffusion difficulty is reduced, which is conducive to improving a doping concentration of impurities in the N-type doped polysilicon layer.

In a possible implementation, a difference value between the refractive index n of the second intrinsic polysilicon layer and the refractive index n of the first intrinsic polysilicon layer is greater than or equal to -0.12 and less than or equal to -0.1.

In a possible implementation, an extinction coefficient k of the second intrinsic polysilicon layer is greater than an extinction coefficient k of the first intrinsic polysilicon layer. In this case, the density of the second intrinsic polysilicon layer is lower than the density of the first intrinsic polysilicon layer. For beneficial effects in this case, reference may be made to the beneficial effects when the refractive index n of the second intrinsic polysilicon layer is less than the refractive index n of the first intrinsic polysilicon layer described above, and details are not described herein.

In a possible implementation, a difference value between the extinction coefficient k of the second intrinsic polysilicon layer and the extinction coefficient k of the first intrinsic polysilicon layer is greater than or equal to 0.02 and less than or equal to 0.3.

In a possible implementation, a formation temperature of the second intrinsic polysilicon layer is greater than a formation temperature of the first intrinsic polysilicon layer. In this case, while other factors are the same, a higher formation temperature indicates a faster deposition rate. Based on this, when the formation temperature of the second intrinsic polysilicon layer is greater than the formation temperature of the first intrinsic polysilicon layer, the second intrinsic polysilicon layer has a relatively fast material deposition rate and a relatively low corresponding film layer density, which is conducive to obtaining a second intrinsic polysilicon layer with a loose structure and a first intrinsic polysilicon layer with a dense structure, further reducing the N-type impurities such as phosphorus with a large size doped into the second intrinsic polysilicon layer in the substitutional diffusion manner, and also preventing a problem of extending through or a large internal extension range after the P-type impurities such as boron atoms with a small size are doped into the first intrinsic polysilicon layer in an interstitial diffusion manner.

In a possible implementation, a formation time of the second intrinsic polysilicon layer is less than a formation time of the first intrinsic polysilicon layer.

In a case that the foregoing technical solution is used, while other factors are the same, a longer formation time indicates a thicker film layer. Based on this, when the formation time of the second intrinsic polysilicon layer is less than the formation time of the first intrinsic polysilicon layer, the first intrinsic polysilicon layer has a larger film layer thickness, further preventing the problem of extending through or a large internal extension range after diffusion.

In a possible implementation, a temperature of the diffusion treatment on the first intrinsic polysilicon layer is greater than a temperature of the diffusion treatment on the second intrinsic polysilicon layer.

In a possible implementation, after the forming a P-type doped polysilicon layer at least on the first region and the forming an N-type doped polysilicon layer at least on the second region, the manufacturing method of a solar cell further includes: performing passivation treatment at least on a side of the P-type doped polysilicon layer facing away from the semiconductor substrate and a side of N-type doped polysilicon layer facing away from the semiconductor substrate, to form a surface passivation layer at least covering the side of the P-type doped polysilicon layer facing away from the semiconductor substrate and the side of the N-type doped polysilicon layer facing away from the semiconductor substrate. After the passivation treatment, a ratio of an extinction coefficient k of the N-type doped polysilicon layer to an extinction coefficient k of the P-type doped polysilicon layer is greater than or equal to 1.5 and less than or equal to 2.5.

In a possible implementation, a ratio of a thickness of the P-type doped polysilicon layer after the passivation treatment to a thickness of the P-type doped polysilicon layer before the passivation treatment is greater than or equal to 0.95 and less than or equal to 1; a ratio of a refractive index n of the P-type doped polysilicon layer after the passivation treatment to a refractive index n of the P-type doped polysilicon layer before the passivation treatment is greater than or equal to 1 and less than or equal to 1.05; and/or a ratio of an extinction coefficient k of the P-type doped polysilicon layer after the passivation treatment to an extinction coefficient k of the P-type doped polysilicon layer before the passivation treatment is greater than or equal to 0.95 and less than or equal to 1.

In a case that the foregoing technical solution is used, the thicknesses of the P-type doped polysilicon layer before and after the passivation treatment are approximately equal, which is conducive to preventing the electrode slurry for manufacturing the negative electrodes from easily penetrating the P-type doped polysilicon layer caused by a large reduction degree of the thickness of the P-type doped polysilicon layer after the passivation treatment, thereby ensuring that the P-type doped polysilicon layer has a high passivation effect. In addition, when the ratio of the refractive index n of the P-type doped polysilicon layer after the passivation treatment to the refractive index n of the P-type doped polysilicon layer before the passivation treatment is greater than or equal to 1 and less than or equal to 1.05; and/or when the ratio of the extinction coefficient k of the P-type doped polysilicon layer after the passivation treatment to the extinction coefficient k of the P-type doped polysilicon layer before the passivation treatment is greater than or equal to 0.95 and less than or equal to 1, the film layer density of the P-type doped polysilicon layer after the passivation treatment is increased, which is further conductive to preventing the electrode slurry for manufacturing the negative electrodes from penetrating the P-type doped polysilicon layer, thereby ensuring that the P-type doped polysilicon layer has a high passivation effect.

In a possible implementation, a ratio of a thickness of the N-type doped polysilicon layer after the passivation treatment to a thickness of the N-type doped polysilicon layer before the passivation treatment is greater than or equal to 0.85 and less than or equal to 0.9; a ratio of a refractive index n of the N-type doped polysilicon layer after the passivation treatment to a refractive index n of the N-type doped polysilicon layer before the passivation treatment is greater than or equal to 0.3 and less than or equal to 1.1; and/or a ratio of an extinction coefficient k of the N-type doped polysilicon layer after the passivation treatment to an extinction coefficient k of the N-type doped polysilicon layer before the passivation treatment is greater than or equal to 1.9 and less than or equal to 2.1.

In a case that the foregoing technical solution is used, the film layer thickness of the N-type doped polysilicon layer is reduced after the passivation treatment, which is conducive to improving the density of the N-type doped polysilicon layer, and preventing the electrode slurry for manufacturing the positive electrodes from penetrating the N-type doped polysilicon layer, thereby ensuring that the N-type doped polysilicon layer has a high passivation effect. Beneficial effects when the ratio of the refractive index n of the N-type doped polysilicon layer after the passivation treatment to the refractive index n of the N-type doped polysilicon layer before the passivation treatment is greater than or equal to 0.3 and less than or equal to 1.1 are similar to the beneficial effects when the ratio of the thickness of the N-type doped polysilicon layer after the passivation treatment to the thickness of the N-type doped polysilicon layer before the passivation treatment is greater than or equal to 0.85 and less than or equal to 0.9, and details are not described herein.

According to a fourth aspect, the present application provides a photovoltaic module. The photovoltaic module includes the solar cell according to the first aspect and various implementations of the first aspect.

For beneficial effects of the fourth aspect and various implementations of the fourth aspect in the present application, reference may be made to the analysis of the beneficial effects of the first aspect and various implementations of the first aspect, and details are not described herein.

### BRIEF DESCRIPTION OF THE DRAWINGS

The accompanying drawings described herein are intended to provide further understanding of the present application and constitute a part of the present application. Exemplary embodiments of the present application and the description thereof are used for explaining the present application rather than constituting an improper limitation to the present application. In the accompanying drawings:
FIG. 1 is a schematic longitudinal cross-sectional view of a first structure of a solar cell according to an embodiment of the present application;
FIG. 2 is a schematic longitudinal cross-sectional view of a second structure of a solar cell according to an embodiment of the present application;
FIG. 3 is a schematic longitudinal cross-sectional view of a third structure of a solar cell according to an embodiment of the present application;
FIG. 4 is a schematic longitudinal cross-sectional view of a fourth structure of a solar cell according to an embodiment of the present application;
FIG. 5 is a schematic longitudinal cross-sectional view of a first structure of a semiconductor structure according to an embodiment of the present application;
FIG. 6 is a schematic longitudinal cross-sectional view of a second structure of a semiconductor structure according to an embodiment of the present application;
FIG. 7 is a first schematic structural diagram of a semiconductor structure in a manufacturing process according to an embodiment of the present application;
FIG. 8 is a second schematic structural diagram of a semiconductor structure in a manufacturing process according to an embodiment of the present application;
FIG. 9 is a third schematic structural diagram of a semiconductor structure in a manufacturing process according to an embodiment of the present application;
FIG. 10 is a fourth schematic structural diagram of a semiconductor structure in a manufacturing process according to an embodiment of the present application;
FIG. 11 is a fifth schematic structural diagram of a semiconductor structure in a manufacturing process according to an embodiment of the present application;
FIG. 12 is a sixth schematic structural diagram of a semiconductor structure in a manufacturing process according to an embodiment of the present application;
FIG. 13 is a schematic diagram of a structure of a solar cell in a manufacturing process according to an embodiment of the present application; and
FIG. 14 is a schematic longitudinal cross-sectional view of a fifth structure of a solar cell according to an embodiment of the present application.

List of reference numerals: 11-Semiconductor substrate, 12-P-type doped polysilicon layer, 13-N-type doped polysilicon layer, 14-Surface passivation layer, 15-Positive electrode, 16-Negative electrode, 17-First tunneling passivation layer, 18-Second tunneling passivation layer, 19-First intrinsic polysilicon layer, and 20-Second intrinsic polysilicon layer.

### DETAILED DESCRIPTION

The embodiments of the present disclosure are described below with reference to the accompanying drawings. However, it should be understood that, the description is merely exemplary, and is not intended to limit a scope of the present disclosure. In addition, in the following description, description of well-known structures and technologies is omitted, to avoid unnecessarily confusing the concept of the present disclosure.

The accompanying drawings show various schematic structural diagrams according to the embodiments of the present disclosure. The accompanying drawings are not drawn to scale, some details are enlarged for the purpose of clarity, and some details may be omitted. Shapes of various regions and layers shown in the drawings, and relative sizes and positional relationships between the various regions and layers are merely exemplary, and may deviate in practice due to manufacturing tolerances or technical limitations, and a person skilled in the art may additionally design regions/layers with different shapes, sizes, and relative positions according to actual requirements.

In the context of the present disclosure, when one layer/element is referred to as being located "on" another layer/element, the layer/element may be directly located on the another layer/element, or an intermediate layer/element may exist between the layer/element and the another layer/element. In addition, if one layer/element is located "above" another layer/element in an orientation, when the orientation is turned, the layer/element may be located "below" the another layer/element. To make the technical problems to be resolved in the present application, the technical solutions, and beneficial effects more comprehensible, the following further describes the present application in detail with reference to the accompanying drawings and the embodiments. It should be understood that, the specific embodiments described herein are merely used to explain the present application but are not intended to limit the present application.

In addition, the terms "first" and "second" are used merely for the purpose of description, and shall not be construed as indicating or implying relative importance or implicitly indicating a quantity of indicated technical features. Therefore, a feature defined by "first" or "second" may explicitly indicate or implicitly include one or more features. In the description of the present application, unless otherwise explicitly specified, "a plurality of" means two or more than two; and unless otherwise explicitly specified, "several" means one or more than one.

In the description of the present application, it should be noted that, unless otherwise explicitly specified or limited, the terms such as "mount", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, internal communication between two elements, or an interactive relationship between two elements. The specific meanings of the foregoing terms in the present application may be understood according to specific situations for a person of ordinary skill in the art.

A solar cell is an apparatus that can convert solar energy into electric energy. Specifically, when the solar cell is in an operating state, sunlight irradiates onto a semiconductor p-n junction of the solar cell to form new hole-electron pairs. Under an action of a built-in electric field of the p-n junction, photogenerated holes flow to a p-type region, and photogenerated electrons flow to an n-type region, so that a current can be generated when a circuit is powered on.

However, in existing solar cells, there is a difference between light refraction effects of an N-type doped polysilicon layer and a P-type doped polysilicon layer, making it difficult to ensure balance between electrons and holes, which is not conducive to improving the operating efficiency of the solar cells.

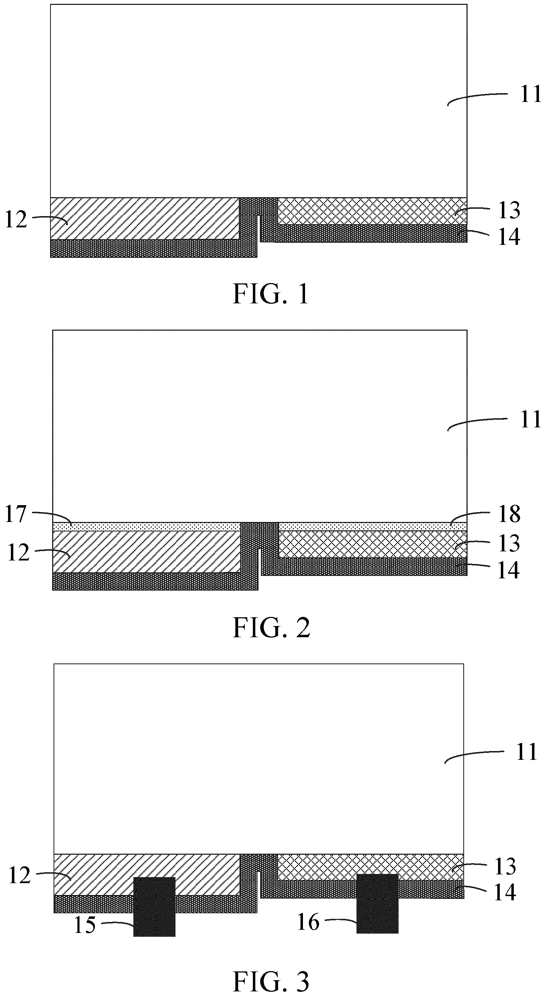

To resolve the foregoing technical problems, according to a first aspect, an embodiment of the present application provides a solar cell. As shown in FIG. 1 to FIG. 4 and FIG. 14, the solar cell provided in this embodiment of the present application includes: a semiconductor substrate 11, a P-type doped polysilicon layer 12, and an N-type doped polysilicon layer 13. The semiconductor substrate 11 includes a first region and a second region. The first region and the second region are located on the same surface of the semiconductor substrate, or the first region and the second region are respectively located on two opposite surfaces of the semiconductor substrate. The N-type doped polysilicon layer 13 is formed at least on the second region. At least a portion of the N-type doped polysilicon layer 13 is spaced apart from at least a portion of the P-type doped polysilicon layer 12. A ratio of a refractive index n of the N-type doped polysilicon layer 13 to a refractive index n of the P-type doped polysilicon layer 12 is greater than or equal to 0.9 and less than or equal to 1.1; and/or an absolute value of a difference value between the refractive index n of the P-type doped polysilicon layer 12 and the refractive index n of the N-type doped polysilicon layer 13 is greater than or equal to 0 and less than or equal to 0.1.

Specifically, in an actual application process, the refractive index n of the N-type doped polysilicon layer and the refractive index n of the P-type doped polysilicon layer may be measured through a test instrument such as an ellipsometer. In a process of testing the refractive index n of the N-type doped polysilicon layer and the refractive index n of the P-type doped polysilicon layer, other film layers (for example, a doped silicate glass layer and/or a surface passivation layer) located on a side of the N-type doped polysilicon layer facing away from the semiconductor substrate and a side of the P-type doped polysilicon layer facing away from the semiconductor substrate need to be removed. In addition, measurement also needs to be performed under the same test conditions, and especially, different film layers on which data comparison needs to be performed further need to be measured under the same test conditions, to improve the accuracy of a measurement result and the accuracy of a comparison result.

In a case that the foregoing technical solution is used, as shown in FIG. 1 to FIG. 4, one of the P-type doped polysilicon layer 12 and the N-type doped polysilicon layer 13 may form a high-low junction with the semiconductor substrate 11, and the other may form a PN junction with the semiconductor substrate 11. Based on this, when the solar cell is in an operating state, after the semiconductor substrate 11 absorbs photons, new hole-electron pairs may be formed. Under an action of built-in electric fields of the PN junction and the high-low junction, photogenerated holes flow to the P-type doped polysilicon layer 12, and photogenerated electrons flow to the N-type doped polysilicon layer 13, so that a current can be generated after a circuit is powered on. Besides, in addition to respectively collecting and transmitting electrons and holes generated in the semiconductor substrate 11, the N-type doped polysilicon layer 13 and the P-type doped polysilicon layer 12 can also generate some electron-hole pairs after absorbing photons to generate electricity. In addition, after light enters the semiconductor substrate 11 from a side of the semiconductor substrate 11 corresponding to a light receiving surface of the solar cell, a part of the light runs through the semiconductor substrate 11 and reaches an interface between the semiconductor substrate 11 and the N-type doped polysilicon layer 13 or an interface between the semiconductor substrate 11 and the P-type doped polysilicon layer 12. In this case, the N-type doped polysilicon layer 13 and the P-type doped polysilicon layer 12 may reflect the part of light, so that the semiconductor substrate 11 absorbs light energy twice, and more electron-hole pairs are generated, thereby improving the light utilization of the semiconductor substrate 11. In the foregoing case, when the ratio of the refractive index n of the N-type doped polysilicon layer 13 to the refractive index n of the P-type doped polysilicon layer 12 falls within the foregoing range, the refractive indexes n of the N-type doped polysilicon layer and the P-type doped polysilicon layer are approximately equal, so that light refraction effects of the N-type doped polysilicon layer 13 and the P-type doped polysilicon layer 12 are approximately the same, which is conducive to ensuring balance between electrons and holes, thereby improving the operating efficiency of the solar cell. In addition, the absolute value of the difference value between the refractive index n of the P-type doped polysilicon layer 12 and the refractive index n of the N-type doped polysilicon layer 13 is greater than or equal to 0 and less than or equal to 0.1. For beneficial effects in this case, reference may be made to the beneficial effects when the ratio of the refractive index n of the N-type doped polysilicon layer 13 to the refractive index n of the P-type doped polysilicon layer 12 is greater than or equal to 0.9 and less than or equal to 1.1 described above, and details are not described herein.

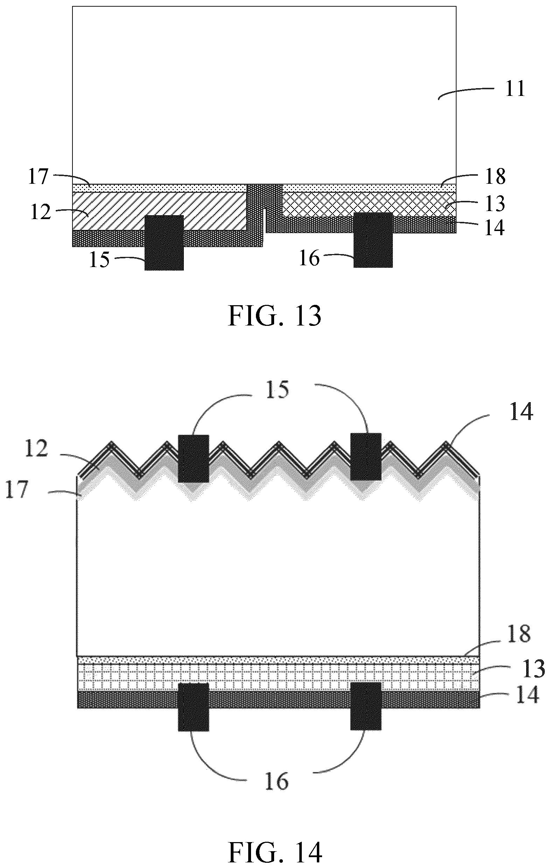

Specifically, as shown in FIG. 14, the solar cell provided in this embodiment of the present application may be a double-sided contact solar cell. In this case, positive electrodes 15 and negative electrodes 16 included by the solar cell are respectively located on a light receiving surface and a back surface of the solar cell. Alternatively, as shown in FIG. 1 to FIG. 4, the solar cell provided in this embodiment of the present application may alternatively be a back contact solar cell. In this case, positive electrodes 15 and negative electrodes 16 included by the solar cell are spaced apart on a back surface of the solar cell.

For the semiconductor substrate, the semiconductor substrate may be any semiconductor substrate such as a silicon substrate, a silicon germanium substrate, a germanium substrate, or a gallium arsenide substrate.

The P-type doped polysilicon layer is formed at least on the first region and the N-type doped polysilicon layer is formed at least on the second region, so that a relative position relationship between the first region and the second region affects a relative position relationship between the P-type doped polysilicon layer and the N-type doped polysilicon layer. Based on this, the relative position relationship between the first region and the second region of the semiconductor substrate may be determined according to a type of the solar cell.

For example, as shown in FIG. 14, when the solar cell provided in this embodiment of the present application is a double-sided contact solar cell, the first region and the second region are respectively located on two opposite surfaces (that is, a first surface and a second surface) of the semiconductor substrate. Specifically, it is defined that the first surface of the semiconductor substrate corresponds to the back surface of the solar cell and the second surface of the semiconductor substrate corresponds to the light receiving surface of the solar cell. In this case, it may be that the first region is located on the first surface of the semiconductor substrate and the second region is located on the second surface of the semiconductor substrate; or it may be that the first region is located on the second surface of the semiconductor substrate and the second region is located on the first surface of the semiconductor substrate. Specifically, the first region and/or the second region may be distributed on the whole surface of the corresponding surface of the semiconductor substrate, or may be distributed on a portion of the corresponding surface. For example, a plurality of first regions and/or second regions exist, and an interval is provided between adjacent first regions or adjacent second regions.

For another example, when the solar cell provided in this embodiment of the present application is a back contact solar cell, the first region and the second region are located on the same surface of the semiconductor substrate, that is, located on a surface of the semiconductor substrate corresponding to the back surface of the solar cell. In this case, a boundary between the first region and the second region of the semiconductor substrate is a virtual boundary. A distribution manner of the first region and the second region is not specifically limited in the embodiments of the present application, provided that the distribution manner can be applied to the solar cell provided in this embodiment of the present application. For example, the first region and the second region may be alternately distributed. For another example, one of the first region and the second region may surround the other. For example, one first region and one second region are respectively approximately T-shaped or comb-shaped and have interdigitated portions that are alternately distributed. The P-type doped polysilicon layer is formed on the first region, so that a range of the first region in the corresponding surface may be determined according to a formation range of the P-type doped polysilicon layer of the solar cell in an actual application scenario. The N-type doped polysilicon layer is formed at least on the second region, so that a range of the second region in the corresponding surface may be determined according to a range of a part of the N-type doped polysilicon layer corresponding to the semiconductor substrate of the solar cell in an actual application scenario. Specifically, the corresponding surface of the semiconductor substrate may include only the first region and the second region; or the corresponding surface of the semiconductor substrate may further include an isolation region in addition to the first region and the second region, and the isolation region is located between the first region and the adjacent second region. A width of the isolation region is not specifically limited in the embodiments of the present application, provided that the width can be applied to the solar cell provided in this embodiment of the present application.

For the P-type doped polysilicon layer and the N-type doped polysilicon layer, in terms of formation positions, as shown in FIG. 1, the P-type doped polysilicon layer 12 may be directly formed on the first region of the semiconductor substrate 11. Alternatively, as shown in FIG. 2, the solar cell may further include a first tunneling passivation layer 17, and the first tunneling passivation layer 17 is located between the P-type doped polysilicon layer 12 and the semiconductor substrate 11. In this case, the first tunneling passivation layer 17 and the P-type doped polysilicon layer 12 may form a tunneling passivation contact structure, to perform chemical passivation on the first region of the semiconductor substrate 11 and selectively collect holes, so that a carrier recombination rate on a side of the semiconductor substrate on which the first tunneling passivation layer 17 is formed is reduced, which is conducive to improving the photoelectric conversion efficiency of the solar cell. A material and a thickness of the first tunneling passivation layer 17 are not specifically limited in the embodiments of the present application. For example, the material of the first tunneling passivation layer 17 may include one or more of silicon oxide, aluminum oxide, titanium oxide, hafnium oxide, gallium oxide, titanium pentoxide, niobium pentoxide, silicon nitride, silicon carbonitride, aluminum nitride, titanium nitride, or titanium carbonitride. The thickness of the first tunneling passivation layer 17 may be greater than or equal to 0.5 nm and less than or equal to 5 nm.

For the N-type doped polysilicon layer, as shown in FIG. 1, the N-type doped polysilicon layer 13 may be directly formed at least on the second region of the semiconductor substrate 11 (for example, the N-type doped polysilicon layer 13 may be formed only on the second region, or the N-type doped polysilicon layer 13 may be formed on the second region and a part of the first region, or the N-type doped polysilicon layer 13 may be formed on the second region and a part of the P-type doped polysilicon layer 12, a specific formation range of the N-type doped polysilicon layer 13 is described in detail below, and details are not described herein). Alternatively, as shown in FIG. 2, the solar cell may further include a second tunneling passivation layer 18, and the second tunneling passivation layer 18 is at least located between the N-type doped polysilicon layer 13 and the semiconductor substrate 11. In this case, the second tunneling passivation layer 18 and the N-type doped polysilicon layer 13 may form a tunneling passivation contact structure, to perform chemical passivation on the second region of the semiconductor substrate 11 and selectively collect electrons, so that a carrier recombination rate on a side of the semiconductor substrate on which the second tunneling passivation layer 18 is formed is reduced, which is conducive to improving the photoelectric conversion efficiency of the solar cell. It may be understood that, a formation range of the second tunneling passivation layer changes along with changes of the formation range of the N-type doped polysilicon layer 13, and the second tunneling passivation layer 18 is arranged on a side of the N-type doped polysilicon layer 13 close to the semiconductor substrate. Specifically, the second tunneling passivation layer 18 is arranged between the N-type doped polysilicon layer 13 and a structure that comes into contact with the second tunneling passivation layer. For a material and a thickness of the second tunneling passivation layer 18, reference may be made to the material and the thickness of the first tunneling passivation layer 17. Specifically, the material of the second tunneling passivation layer 18 may be the same as or different from the material of the first tunneling passivation layer 17. The thickness of the second tunneling passivation layer 18 may be the same as or different from the thickness of the first tunneling passivation layer 17.

**In** terms of formation ranges, in a case that the first region and the second region are respectively located on two opposite surfaces of the semiconductor substrate, the P-type doped polysilicon layer may be spaced apart from the N-type doped polysilicon layer through a side surface of the semiconductor substrate. The P-type doped polysilicon layer may be formed only on the first region, and the N-type doped polysilicon layer may be formed only on the second region. In a special case, the P-type doped polysilicon layer and the N-type doped polysilicon layer may come into contact at a partial preset position of the side surface of the semiconductor substrate, and are spaced apart from each other at a part other than the partial preset position on the side surface of the semiconductor substrate. In this way, a partial current leakage point is formed, so that a reverse breakdown voltage of the solar cell is effectively reduced, and an anti-hot spot risk capability of the solar cell is improved.

In a case that the first region and the second region are located on the same surface of the semiconductor substrate, the P-type doped polysilicon layer may be formed only on the first region; or the P-type doped polysilicon layer is not only formed on the first region, and may be further formed on a part of the second region (in a case that the corresponding surface of the semiconductor substrate includes the first region, the second region, and the isolation region, the P-type doped polysilicon layer may be formed on the first region and further formed on a part of the isolation region and/or a part of the second region). When the P-type doped polysilicon layer is further formed on a part of the second region, a relative position relationship between a part of the P-type doped polysilicon layer corresponding to the second region and the N-type doped polysilicon layer may be determined according to an actual manufacturing process. For example, if a formation sequence of the P-type doped polysilicon layer is after that of the N-type doped polysilicon layer, the part of the P-type doped polysilicon layer corresponding to the second region is located on the N-type doped polysilicon layer; and if the formation sequence of the P-type doped polysilicon layer is before that of the N-type doped polysilicon layer, the part of the P-type doped polysilicon layer corresponding to the second region is located below the N-type doped polysilicon layer.

For the N-type doped polysilicon layer in the case that the first region and the second region are located on the same surface of the semiconductor substrate, the N-type doped polysilicon layer may be formed only on the second region; or the N-type doped polysilicon layer is not only formed on the second region, and may be further formed on a part of the first region (in a case that the corresponding surface of the semiconductor substrate includes the first region, the second region, and the isolation region, the N-type doped polysilicon layer may be formed on the second region and further formed on a part of the isolation region and/or a part of the first region). A part of the N-type doped polysilicon layer corresponding to the first region may be located on a part of a side of the P-type doped polysilicon layer facing away from the semiconductor substrate, or a part of the N-type doped polysilicon layer corresponding to the first region may alternatively be located below the P-type doped polysilicon layer, and relative positions of the N-type doped polysilicon layer and the P-type doped polysilicon layer may be determined according to an actual manufacturing process.

In a case that the first region and the second region are located on the same surface of the semiconductor substrate, a whole region of the N-type doped polysilicon layer may be spaced apart from a whole region of the P-type doped polysilicon layer; or only a portion of the N-type doped polysilicon layer may be spaced apart from only a portion of the P-type doped polysilicon layer, to reduce a hot spot risk through partial electrical contact between the N-type doped polysilicon layer and the P-type doped polysilicon layer, thereby improving the operating reliability of a photovoltaic module including the solar cell provided in this embodiment of the present application. Specifically, when only a portion of the N-type doped polysilicon layer is spaced apart from only a portion of the P-type doped polysilicon layer, a range, a position, and a distribution situation of the partial electrical contact between the N-type doped polysilicon layer and the P-type doped polysilicon layer may be set according to actual requirements, which are not specifically limited herein. In addition, parts of the N-type doped polysilicon layer and the P-type doped polysilicon layer that need to be spaced apart may be isolated through the isolation region described above, or may be isolated through an insulating material or an intrinsic semiconductor material.

In terms of film layer thicknesses, a thickness of the P-type doped polysilicon layer and a thickness of the N-type doped polysilicon layer are not specifically limited in the embodiments of the present application. In an embodiment, the thickness of the N-type doped polysilicon layer is less than the thickness of the P-type doped polysilicon layer. In this case, the P-type doped polysilicon layer is generally formed by performing boron diffusion on a first intrinsic polysilicon layer for manufacturing the P-type doped polysilicon layer. Boron atoms have a relatively small size and a corresponding diffusion manner is interstitial diffusion, so that when the P-type doped polysilicon layer has a relatively large thickness, the problem of extending through or a large internal extension range of the P-type doped polysilicon layer after diffusion treatment can be alleviated. In a case that the solar cell further includes the first tunneling passivation layer, the first tunneling passivation layer may be further prevented from being extended through, thereby ensuring that the first tunneling passivation layer has good passivation performance.

A difference value or a ratio between the thicknesses and specific values of the thicknesses of the N-type doped polysilicon layer and the P-type doped polysilicon layer may be determined according to an actual application scenario.

For example, the difference value between the thickness of the N-type doped polysilicon layer and the thickness of the P-type doped polysilicon layer may be greater than or equal to - 140 nm and less than or equal to -100 nm. For example, the difference value between the thickness of the N-type doped polysilicon layer and the thickness of the P-type doped polysilicon layer may be -140 nm, -130 nm, -120 nm, -110 nm, -105 nm, or -100 nm.

For example, the thickness of the N-type doped polysilicon layer may be greater than or equal to 100 nm and less than or equal to 240 nm. For example, the thickness of the N-type doped polysilicon layer may be 100 nm, 120 nm, 140 nm, 160 nm, 180 nm, 190 nm, 200 nm, 210 nm, 220 nm, 230 nm, or 240 nm.

For example, the thickness of the P-type doped polysilicon layer may be greater than or equal to 150 nm and less than or equal to 340 nm. For example, the thickness of the P-type doped polysilicon layer may be 150 nm, 180 nm, 200 nm, 220 nm, 240 nm, 260 nm, 280 nm, 290 nm, 300 nm, 310 nm, 320 nm, 330 nm, or 340 nm.

In terms of doping, a doping type, a doping concentration, and a doping depth of impurities in the P-type doped polysilicon layer and the N-type doped polysilicon layer are not specifically limited in the embodiments of the present application, provided that the values can be applied to the solar cell provided in this embodiment of the present application.

In an embodiment, the impurities in the N-type doped polysilicon layer may include phosphorus, and the impurities in the P-type doped polysilicon layer may include boron. Phosphorus atoms have a relatively large size, and are generally doped into a second intrinsic polysilicon layer for manufacturing the N-type doped polysilicon layer in a substitutional diffusion manner. Boron atoms have a relatively small size, and are generally doped into the first intrinsic polysilicon layer for manufacturing the P-type doped polysilicon layer in an interstitial diffusion manner.

In an embodiment, a doping concentration of the impurities in the N-type doped polysilicon layer may be greater than a doping concentration of the impurities in the P-type doped polysilicon layer. It may be understood that, under a limitation of factors such as a doping solid concentration, improvement of the doping concentration of the impurities in the P-type doped polysilicon layer is limited. Therefore, when the doping concentration of the impurities in the N-type doped polysilicon layer is greater than the doping concentration of the impurities in the P-type doped polysilicon layer, the doping difficulty of the P-type doped polysilicon layer can be reduced, and it is ensured that the N-type doped polysilicon layer has a relatively high field passivation effect and relatively low contact resistance between the N-type doped polysilicon layer and the negative electrodes. Specifically, when the doping concentration of the impurities in the N-type doped polysilicon layer is greater than the doping concentration of the impurities in the P-type doped polysilicon layer, a ratio or a difference value between the doping concentrations may be determined according to an actual application scenario.

For example, the ratio of the doping concentration of the impurities in the N-type doped polysilicon layer to the doping concentration of the impurities in the P-type doped polysilicon layer may be greater than or equal to 5 and less than or equal to 10.

In an embodiment, a doping depth of the impurities corresponding to the P-type doped polysilicon layer may be greater than a doping depth of the impurities corresponding to the N-type doped polysilicon layer. In this case, an etching depth of the electrode slurry corresponding to the positive electrodes on the P-type doped polysilicon layer may be increased, to increase a contact area between the electrode slurry and the P-type doped polysilicon layer, to further reduce contact resistance between the electrode slurry and the P-type doped polysilicon layer.

In terms of optical parameters of film layers, values of an extinction coefficient k of the N-type doped polysilicon layer and an extinction coefficient k of the P-type doped polysilicon layer are not specifically limited, provided that the values can be applied to the solar cell provided in this embodiment of the present application. Specifically, as described in this specification, the extinction coefficient k of the N-type doped polysilicon layer and the extinction coefficient k of the P-type doped polysilicon layer are related to densities of the film layers, and further affect anti-etching capabilities of the film layers against the electrode slurry. In addition, operations such as passivation treatment in a manufacturing process of the solar cell affect the density and the extinction coefficient k of the film layer. Based on this, a difference value and a ratio between the extinction coefficient k of the N-type doped polysilicon layer and the extinction coefficient k of the P-type doped polysilicon layer and specific values thereof may be determined according to a specific structure of the solar cell and etching capabilities of the electrode slurries corresponding to the positive electrodes and the negative electrodes in an actual application scenario.

For example, the extinction coefficient k of the N-type doped polysilicon layer may be greater than the extinction coefficient k of the P-type doped polysilicon layer.

Specifically, in an actual application process, the extinction coefficient k of the N-type doped polysilicon layer and the extinction coefficient k of the P-type doped polysilicon layer may be measured through a test instrument such as an ellipsometer. In a process of testing the extinction coefficient k of the N-type doped polysilicon layer and the extinction coefficient k of the P-type doped polysilicon layer, other film layers (for example, a doped silicate glass layer and/or a surface passivation layer) located on a side of the N-type doped polysilicon layer facing away from the semiconductor substrate and a side of the P-type doped polysilicon layer facing away from the semiconductor substrate need to be removed. In addition, measurement also needs to be performed under the same test conditions, and especially, different film layers on which data comparison needs to be performed further need to be measured under the same test conditions, to improve the accuracy of a measurement result and the accuracy of a comparison result.

In a case that the foregoing technical solution is used, as shown in FIG. 1 to FIG. 4, since conductivity types of carriers to be collected by the P-type doped polysilicon layer 12 and the N-type doped polysilicon layer 13 are different, compositions of the electrode slurry for manufacturing the positive electrodes 15 electrically connected to the P-type doped polysilicon layer 12 and the electrode slurry for manufacturing the negative electrodes 16 electrically connected to the N-type doped polysilicon layer 13 are correspondingly different (that the compositions of the electrode slurry corresponding to the positive electrodes 15 and the electrode slurry corresponding to the negative electrodes 16 are different may indicate that compositions and/or content of additives in the slurries are not completely the same, for example, content of glass composite in the electrode slurry corresponding to the positive electrodes 15 is different from content of glass composite in the electrode slurry corresponding to the negative electrodes 16; or conductive compositions in the slurries are not completely the same, for example, conductive compositions in the electrode slurry corresponding to the positive electrodes 15 may be silver and aluminum, and compositions in the electrode slurry corresponding to the negative electrodes 16 is silver), to ensure that the positive electrodes 15 have a relatively high hole transmission rate and ensure that the negative electrodes 16 have a relatively high electron transmission rate. Conventionally, positive electrodes 15 and negative electrodes 16 that have different slurry compositions have different film layer etching capabilities, an etching depth of the positive electrodes 15 is far greater than that of the negative electrodes 16 for film layers with the same density, and the positive electrodes 15 have a greater burn-through risk. By adjusting a density of the P-type doped polysilicon layer 12 and a density of the N-type doped polysilicon layer 13, the P-type doped polysilicon layer 12 is denser, and etching resistance to the positive electrodes is increased, so that the etching depth of the positive electrodes is reduced, and the positive electrodes stay at a suitable depth. In addition, the extinction coefficient k of the N-type doped polysilicon layer 13 and the extinction coefficient k of the P-type doped polysilicon layer 12 are related to the film layer densities of the N-type doped polysilicon layer and the P-type doped polysilicon layer. Within a specific range, the extinction coefficient k of the N-type doped polysilicon layer 13 and the extinction coefficient k of the P-type doped polysilicon layer 12 are inversely proportional to the film layer densities of the N-type doped polysilicon layer and the P-type doped polysilicon layer. Based on this, the film layer densities of the N-type doped polysilicon layer 13 and the P-type doped polysilicon layer 12 may be regulated by adjusting a magnitude relationship between the extinction coefficients k of the two film layers. By setting the extinction coefficient k of the N-type doped polysilicon layer 13 to be greater than the extinction coefficient k of the P-type doped polysilicon layer 12, the P-type doped polysilicon layer 12 has a relatively high density, and the P-type doped polysilicon layer 12 has a relatively high capability against etching by the electrode slurry, so that the manufactured positive electrodes 15 are prevented from penetrating the P-type doped polysilicon layer 12. Therefore, a matching degree between the P-type doped polysilicon layer 12 and the electrode slurry corresponding to the positive electrodes 15 is improved, and it is ensured that the P-type doped polysilicon layer 12 has a relatively high field passivation effect, thereby reducing a carrier recombination rate on a back surface, and improving the operating performance of the solar cell.

For example, as shown in FIG. 1 and FIG. 2, in a case that the solar cell further includes a surface passivation layer 14 and the surface passivation layer 14 at least covers the side of the P-type doped polysilicon layer 12 facing away from the semiconductor substrate 11 and the side of the N-type doped polysilicon layer 13 facing away from the semiconductor substrate 11, the ratio of the extinction coefficient k of the N-type doped polysilicon layer 13 to the extinction coefficient k of the P-type doped polysilicon layer 12 may be greater than or equal to 1.5 and less than or equal to 2.5; and/or the difference value between the extinction coefficient k of the N-type doped polysilicon layer 13 and the extinction coefficient k of the P-type doped polysilicon layer 12 may be greater than or equal to 0.2 and less than or equal to 0.5.

For example, in a case that the solar cell further includes the surface passivation layer, the ratio of the N-type doped polysilicon layer to the extinction coefficient k of the P-type doped polysilicon layer may be 1.5, 1.8, 1.85, 1.9, 1.95, 2.0, 2.05, 2.1, 2.2, 2.3, 2.4, or 2.5. For example, in a case that the solar cell further includes the surface passivation layer, the difference value between the extinction coefficient k of the N-type doped polysilicon layer and the extinction coefficient k of the P-type doped polysilicon layer may be 0.2, 0.3, 0.32, 0.34, 0.36, 0.38, 0.4, 0.45, or 0.5.

In a case that the foregoing technical solution is used, the ratio of the extinction coefficient k of the N-type doped polysilicon layer to the extinction coefficient k of the P-type doped polysilicon layer falls within the foregoing range, so that a case that the negative electrodes easily penetrate the N-type doped polysilicon layer caused by an excessively loose film layer of the N-type doped polysilicon layer due to a large ratio is prevented, thereby ensuring that the N-type doped polysilicon layer has a relatively high field passivation effect. In addition, in a case that the first region and the second region are located on the same surface or the first region is located in a portion of a surface, large etching difficulty and low etching efficiency during patterning treatment on the P-type doped polysilicon layer deposited as a whole caused by an excessively dense film layer of the P-type doped polysilicon layer due to the large ratio may be further prevented, so that difficulty in manufacturing the solar cell is reduced and the manufacturing efficiency of the solar cell is improved. In addition, a small contact area between the formed positive electrodes and the P-type doped polysilicon layer caused by the excessively dense P-type doped polysilicon layer may be further prevented, thereby ensuring small contact resistance between the positive electrodes and the negative electrodes. In addition, the ratio of the extinction coefficient k of the N-type doped polysilicon layer to the extinction coefficient k of the P-type doped polysilicon layer falls within the foregoing range, so that a small improvement degree of the density of the P-type doped polysilicon layer due to a small ratio may be further prevented, which is conducive to reducing a metal recombination loss between the positive electrodes and the P-type doped polysilicon layer while ensuring that the positive electrodes do not penetrate the P-type doped polysilicon layer, thereby ensuring that the solar cell has relatively high operating performance.

For example, the extinction coefficient k of the P-type doped polysilicon layer may be greater than or equal to 0.20 and less than or equal to 0.40. For example, the extinction coefficient k of the P-type doped polysilicon layer may be 0.20, 0.21, 0.22, 0.23, 0.24, 0.25, 0.26, 0.27, 0.28, 0.29, 0.30, 0.31, 0.32, 0.33, 0.34, 0.35, 0.36, 0.37, 0.38, 0.39, or 0.40.

For example, the extinction coefficient k of the N-type doped polysilicon layer may be greater than or equal to 0.50 and less than or equal to 0.74. For example, the extinction coefficient k of the N-type doped polysilicon layer may be 0.50, 0.51, 0.52, 0.53, 0.54, 0.55, 0.56, 0.57, 0.58, 0.59, 0.60, 0.61, 0.62, 0.63, 0.64, 0.65, 0.66, 0.67, 0.68, 0.69, 0.70, 0.71, 0.72, 0.73, or 0.74.

It should be noted that, as described above, when other film layers are formed on the side of the P-type doped polysilicon layer facing away from the semiconductor substrate and the side of the N-type doped polysilicon layer facing away from the semiconductor substrate, the other film layers formed on the side of the P-type doped polysilicon layer facing away from the semiconductor substrate and the side of the N-type doped polysilicon layer facing away from the semiconductor substrate need to be removed; and under the same test conditions, the extinction coefficient k of the P-type doped polysilicon layer and the extinction coefficient k of the N-type doped polysilicon layer are then measured through a test instrument such as an ellipsometer, to improve the accuracy of a comparison result. For example, when the surface passivation layer is formed on the side of the P-type doped polysilicon layer facing away from the semiconductor substrate and the side of the N-type doped polysilicon layer facing away from the semiconductor substrate, the surface passivation layer needs to be removed, and the extinction coefficient k of the P-type doped polysilicon layer and the extinction coefficient k of the N-type doped polysilicon layer are then tested under the same test conditions.

In addition, in an actual application process, in addition to the extinction coefficient k, the optical parameters corresponding to the N-type doped polysilicon layer and the P-type doped polysilicon layer further includes parameters such as a refractive index n. The refractive index n of the N-type doped polysilicon layer and the refractive index n of the P-type doped polysilicon layer are also related to the densities of the film layers. Specifically, within a specific range, the refractive index n corresponding to the N-type doped polysilicon layer and the refractive index n corresponding to the P-type doped polysilicon layer are positively proportional to the densities of the film layers. Besides, as described above, in addition to respectively collecting and transmitting electrons and holes generated in the semiconductor substrate, the N-type doped polysilicon layer and the P-type doped polysilicon layer can also generate some electron-hole pairs after absorbing photons to generate electricity. In addition, after light enters the semiconductor substrate from a side of the semiconductor substrate corresponding to a light receiving surface of the solar cell, a part of the light runs through the semiconductor substrate and reaches an interface between the semiconductor substrate and the N-type doped polysilicon layer or an interface between the semiconductor substrate and the P-type doped polysilicon layer. In this case, the N-type doped polysilicon layer and the P-type doped polysilicon layer may reflect the part of light, so that the semiconductor substrate absorbs light energy twice, and more electron-hole pairs are generated, thereby improving the light utilization of the semiconductor substrate. Based on this, the refractive index n of the N-type doped polysilicon layer and the refractive index n of the P-type doped polysilicon layer reflect light refraction capabilities of the two film layers, and further affect an amount of light reflected by the two film layers into the semiconductor substrate. In the foregoing case, specific values of the refractive indexes may be determined according to the densities of the N-type doped polysilicon layer and the P-type doped polysilicon layer and light reflection and refraction requirements in an actual application scenario.

A ratio of the refractive index n of the N-type doped polysilicon layer to the refractive index n of the P-type doped polysilicon layer may be any value greater than or equal to 0.9 and less than or equal to 1.1. For example, the ratio of the refractive index n of the N-type doped polysilicon layer to the refractive index n of the P-type doped polysilicon layer may be 0.9, 0.92. 0.94, 0.96, 0.98, 1.0, 1.02, 1.04, 1.06, or 1.1. In the foregoing case, when the ratio of the refractive index n of the N-type doped polysilicon layer to the refractive index n of the P-type doped polysilicon layer falls within the foregoing range, the refractive indexes n of the N-type doped polysilicon layer and the P-type doped polysilicon layer are approximately equal, so that light refraction effects of the N-type doped polysilicon layer and the P-type doped polysilicon layer are approximately the same, which is conducive to ensuring balance between electrons and holes, thereby improving the operating efficiency of the solar cell.

An absolute value of a difference value between the refractive index n of the P-type doped polysilicon layer and the refractive index n of the N-type doped polysilicon layer may be any value greater than or equal to 0 and less than or equal to 0.1. For example, the absolute value of the difference value between the refractive index n of the P-type doped polysilicon layer and the refractive index n of the N-type doped polysilicon layer may be 0, 0.01, 0.02, 0.03, 0.04, 0.05, 0.06, 0.07, 0.08, 0.09, or 0.1. In the foregoing case, when the ratio of the refractive index n of the N-type doped polysilicon layer to the refractive index n of the P-type doped polysilicon layer falls within the foregoing range, the refractive indexes n of the N-type doped polysilicon layer and the P-type doped polysilicon layer are approximately equal, so that light refraction effects of the N-type doped polysilicon layer and the P-type doped polysilicon layer are approximately the same, which is conducive to ensuring balance between electrons and holes, thereby improving the operating efficiency of the solar cell. A smaller absolute value of the difference value between the refractive index n of the P-type doped polysilicon layer and the refractive index n of the N-type doped polysilicon layer indicates a better effect. In addition, a difference between the thickness of the P-type doped polysilicon layer and the thickness of the N-type doped polysilicon layer is reduced by adjusting the extinction coefficient k, and a smaller difference value between the thickness of the P-type doped polysilicon layer and the thickness of the N-type doped polysilicon layer indicates a smaller absolute value of the difference value between the refractive index n of the P-type doped polysilicon layer and the refractive index n of the N-type doped polysilicon layer that are actually obtained and high cell efficiency.

For example, the refractive index n of the P-type doped polysilicon layer may be greater than or equal to 1 and less than or equal to 3.96. For example, the refractive index n of the P-type doped polysilicon layer may be 1, 1.2, 1.4, 1.6, 1.8, 2.0, 2.2, 2.4, 2.6, 2.8, 3.0, 3.2, 3.4, 3.6, 3.8, 3.9, 3.91, 3.92, 3.93, 3.94, 3.95, or 3.96.

For example, the refractive index n of the N-type doped polysilicon layer may be greater than or equal to 1 and less than or equal to 4. For example, the refractive index n of the N-type doped polysilicon layer may be 1, 1.2, 1.4, 1.6, 1.8, 2.0, 2.2, 2.4, 2.6, 2.8, 3.0, 3.2, 3.4, 3.6, 3.8, 3.9, 3.98, 3.982, 3.984, 3.986, 3.988, 3.990, 3.995, or 4.

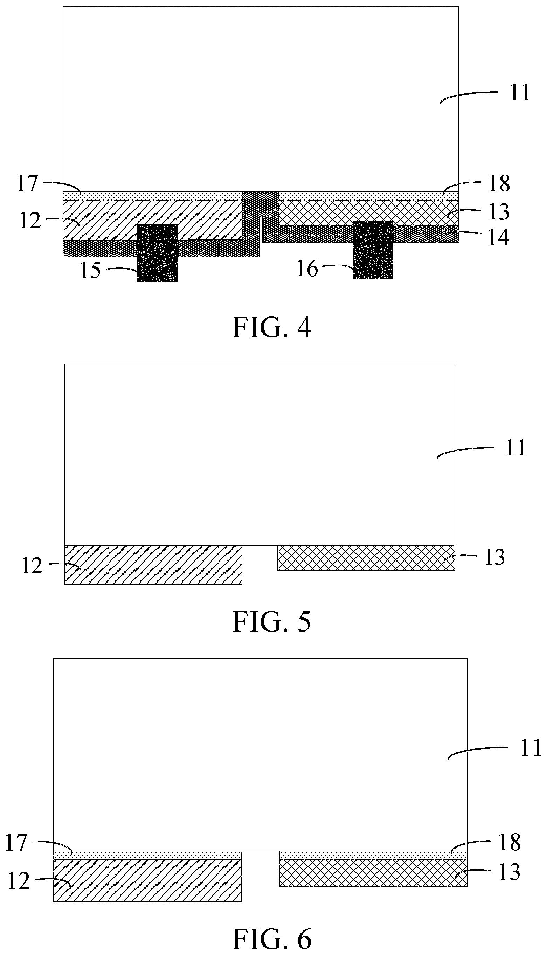

In an actual application process, as shown in FIG. 3 and FIG. 4, the solar cell further includes positive electrodes 15 that are in ohmic contact with the P-type doped polysilicon layer 12 and negative electrodes 16 that are in ohmic contact with the N-type doped polysilicon layer 13. Materials of the positive electrodes 15 and the negative electrodes 16 may include any conductive material such as silver, aluminum, copper, titanium, or nickel. Specifically, in an actual manufacturing process, since the electrode slurries for manufacturing the positive electrodes 15 and the negative electrodes 16 have a specific etching feature, after the positive electrodes 15 and the negative electrodes 16 are formed, the positive electrodes and the negative electrodes respectively extend by a specific depth into the P-type doped polysilicon layer 12 and the N-type doped polysilicon layer 13 along a thickness direction of the semiconductor substrate 11. A value of the depth is not only related to the etching feature of the electrode slurries, but also related to factors such as the film layer densities of the P-type doped polysilicon layer 12 and the N-type doped polysilicon layer 13. In addition, the value of the depth further affects a contact area between the positive electrodes 15 and the P-type doped polysilicon layer 12 and a contact area between the negative electrodes 16 and the N-type doped polysilicon layer 13 respectively, and further affects contact resistance. Based on this, a depth by which the positive electrodes 15 extend into the P-type doped polysilicon layer 12 and a depth by which the negative electrodes 16 extend into the N-type doped polysilicon layer 13 may be determined according to a capability against etching by the electrode slurry of the film layers of the P-type doped polysilicon layer 12 and the N-type doped polysilicon layer 13 and a requirement on the contact resistance in an actual application scenario.

For example, as shown in FIG. 3 and FIG. 4, along the thickness direction of the semiconductor substrate 11, a depth by which at least a part of the positive electrodes 15 extend into the P-type doped polysilicon layer 12 may be greater than or equal to a depth by which at least a part of the negative electrodes 16 extend into the N-type doped polysilicon layer 13. In this case, when the depth by which at least a part of the positive electrodes 15 extend into the P-type doped polysilicon layer 12 is greater than or equal to the depth by which at least a part of the negative electrodes 16 extend into the N-type doped polysilicon layer 13, it helps increase a contact area corresponding to the part with a large extending depth of the positive electrodes 15 into the P-type doped polysilicon layer 12, and reduces contact resistance between the positive electrodes 15 and the P-type doped polysilicon layer 12, which is conducive to reducing a transmission loss during transmission of holes from the P-type doped polysilicon layer 12 to the positive electrodes 15, thereby further improving the operating performance of the solar cell. In addition, in an actual application process, due to factors such as a limitation of a doping solid concentration, a doping concentration of impurities in the P-type doped polysilicon layer 12 is generally less than a doping concentration of impurities in the N-type doped polysilicon layer 13, so that when the depth by which at least a part of the positive electrodes 15 extend into the P-type doped polysilicon layer 12 is greater than or equal to the depth by which the at least a part of the negative electrodes 16 extend into the N-type doped polysilicon layer 13, a large metal recombination area between the N-type doped polysilicon layer and the negative electrodes caused by a large contact area between the N-type doped polysilicon layer 13 and the negative electrodes 16 is further prevented, thereby ensuring a small recombination loss between the N-type doped polysilicon layer 13 and the negative electrodes 16.

For example, along the thickness direction of the semiconductor substrate, the depth by which at least a part of the positive electrodes extend into the P-type doped polysilicon layer may be greater than or equal to 80 nm and less than or equal to 100 nm. For example, along the thickness direction of the semiconductor substrate, the depth by which at least a part of the positive electrodes extend into the P-type doped polysilicon layer may be 80 nm, 85 nm, 90 nm, 95 nm, or 100 nm. In this case, along the thickness direction of the semiconductor substrate, the depth by which at least a part of the positive electrodes extend into the P-type doped polysilicon layer falls within the foregoing range, which is conducive to preventing a small contact area between the positive electrodes and the P-type doped polysilicon layer caused by a small depth and is conducive to reducing contact resistance between the positive electrodes and the P-type doped polysilicon layer. In addition, this is also conducive to preventing an excessively large contact area between the positive electrodes and the P-type doped polysilicon layer caused by a large depth and is conducive to reducing a metal recombination loss between the positive electrodes and the P-type doped polysilicon layer. Based on the above, the depth by which the positive electrodes extend into the P-type doped polysilicon layer falls within the foregoing range, which is conducive to balancing the contact resistance and the metal recombination loss between the positive electrodes and the P-type doped polysilicon layer, thereby ensuring that the solar cell has relatively high operating performance.

For example, along the thickness direction of the semiconductor substrate, the depth by which at least a part of the negative electrodes extend into the N-type doped polysilicon layer may be greater than or equal to 50 nm and less than or equal to 80 nm. For example, the depth by which at least a part of the negative electrodes extend into the N-type doped polysilicon layer may be 50 nm, 55 nm, 60 nm, 65 nm, 70 nm, 75 nm, or 80 nm. Beneficial effects in this case are similar to the beneficial effects of the case that the depth by which at least a part of the positive electrodes extend into the P-type doped polysilicon layer is greater than or equal to 80 nm and less than or equal to 100 nm described above, and details are not described herein.

According to a second aspect, an embodiment of the present application provides a semiconductor structure. As shown in FIG. 5 and FIG. 6, the semiconductor structure includes: a semiconductor substrate 11, a P-type doped polysilicon layer 12, and an N-type doped polysilicon layer 13. The semiconductor substrate 11 includes a first region and a second region. The first region and the second region may be located on the same surface of the semiconductor substrate, or may be respectively located on two opposite surfaces of the semiconductor substrate. FIG. 5 and FIG. 6 show a schematic structural diagram when the first region and the second region are located on the same surface of the semiconductor substrate, and FIG. 14 shows a schematic structural diagram when the first region and the second region are located on two opposite surfaces of the semiconductor substrate. The P-type doped polysilicon layer 12 is formed at least on the first region. The N-type doped polysilicon layer 13 is formed at least on the second region. At least a portion of the N-type doped polysilicon layer 13 is spaced apart from at least a portion of the P-type doped polysilicon layer 12. A ratio of a refractive index n of the N-type doped polysilicon layer to a refractive index n of the P-type doped polysilicon layer may be greater than or equal to 0.8 and less than or equal to 1.2; and/or an absolute value of a difference value between the refractive index n of the P-type doped polysilicon layer and the refractive index n of the N-type doped polysilicon layer may be greater than or equal to 0 and less than or equal to 0.2. In this case, in a solar cell manufactured based on the semiconductor structure provided in this embodiment of the present application, the refractive index n of the N-type doped polysilicon layer and the refractive index n of the P-type doped polysilicon layer are approximately equal. For beneficial effects when the refractive index n of the N-type doped polysilicon layer and the refractive index n of the P-type doped polysilicon layer in the solar cell are approximately equal, reference may be made to the foregoing description, and details are not described herein.

The ratio or the difference value between the refractive index n of the N-type doped polysilicon layer and the refractive index n of the P-type doped polysilicon layer and specific values of the refractive indexes n may be determined according to a requirement on light refraction effects of the N-type doped polysilicon layer and the P-type doped polysilicon layer and a requirement on film layer densities of the N-type doped polysilicon layer and the P-type doped polysilicon layer in an actual application scenario.

For example, the ratio of the refractive index n of the N-type doped polysilicon layer to the refractive index n of the P-type doped polysilicon layer is 0.8, 0.85. 0.9, 0.95, 1, 1.05, 1.1, 1.15, or 1.2. For example, the absolute value of the difference value between the refractive index n of the P-type doped polysilicon layer and the refractive index n of the N-type doped polysilicon layer may be 0.01, 0.02, 0.06, 0.08, 0.1, 0.12, 0.14, 0.18, or 0.2.

For example, the refractive index n of the P-type doped polysilicon layer may be greater than or equal to 3.8 and less than or equal to 4. For example, the refractive index n of the P-type doped polysilicon layer may be 3.8, 3.82, 3.85, 3.88, 3.9, 3.95, or 4.

For example, the refractive index n of the N-type doped polysilicon layer may be greater than or equal to 3.7 and less than or equal to 3.95. For example, the refractive index n of the N-type doped polysilicon layer may be 3.7, 3.75, 3.8, 3.85, 3.88, 3.9, 3.92, 3.94, or 3.95.

A ratio or a difference value between an extinction coefficient k of the N-type doped polysilicon layer and an extinction coefficient k of the P-type doped polysilicon layer and specific values of the extinction coefficients k may be determined according to a requirement on the film layer densities of the N-type doped polysilicon layer and the P-type doped polysilicon layer according to an actual application scenario.

For example, the ratio of the extinction coefficient k of the N-type doped polysilicon layer 13 to the extinction coefficient k of the P-type doped polysilicon layer 12 is greater than or equal to 1 and less than or equal to 1.2; and/or the difference value between the extinction coefficient k of the N-type doped polysilicon layer 13 and the extinction coefficient k of the P-type doped polysilicon layer 12 is greater than 0 and less than or equal to 0.1.

Specifically, the ratio of the extinction coefficient k of the N-type doped polysilicon layer to the extinction coefficient k of the P-type doped polysilicon layer may be any value greater than 1 and less than or equal to 2.6. For example, the ratio of the extinction coefficient k of the N-type doped polysilicon layer to the extinction coefficient k of the P-type doped polysilicon layer may be 1.01, 1.02, 1.06, 1.08, 1.1, 1.12, 1.16, 1.18, 1.2, 1.3, 1.4, 1.6, 1.8, 2.0, 2.2, 2.4, or 2.6.

The difference value between the extinction coefficient k of the N-type doped polysilicon layer and the extinction coefficient k of the P-type doped polysilicon layer may be any value greater than 0 and less than or equal to 0.2. For example, the difference value between the extinction coefficient k of the N-type doped polysilicon layer and the extinction coefficient k of the P-type doped polysilicon layer may be 0.01, 0.02, 0.04, 0.06, 0.08, 0.1, 0.12, 0.14, 0.16, 0.18, or 0.2. The specific values of the extinction coefficient k of the N-type doped polysilicon layer and the extinction coefficient k of the P-type doped polysilicon layer may be determined according to an actual application scenario, which are not specifically limited herein.

For example, the extinction coefficient k of the N-type doped polysilicon layer may be greater than or equal to 0.27 and less than or equal to 0.41. For example, the extinction coefficient k of the N-type doped polysilicon layer may be 0.27, 0.28, 0.29, 0.30, 0.31, 0.32, 0.33, 0.34, 0.35, 0.36, 0.37, 0.38, 0.39, 0.40, or 0.41.

For example, the extinction coefficient k of the P-type doped polysilicon layer may be greater than or equal to 0.1 and less than or equal to 0.38. For example, the extinction coefficient k of the P-type doped polysilicon layer may be 0.1, 0.12, 0.14, 0.16, 0.18, 0.2, 0.22, 0.24, 0.25, 0.26, 0.27, 0.28, 0.29, 0.30, 0.31, 0.32, 0.33, 0.34, 0.35, 0.36, 0.37, or 0.38.

It may be understood that, the semiconductor structure provided in this embodiment of the present application is configured for manufacturing an intermediate state structure or a semi-finished product of the solar cell described above. Based on this, when the ratio of the extinction coefficient k of the N-type doped polysilicon layer to the extinction coefficient k of the P-type doped polysilicon layer in the semiconductor structure provided in this embodiment of the present application is greater than 1 and less than or equal to 2.6; and/or when the difference value between the extinction coefficient k of the N-type doped polysilicon layer and the extinction coefficient k of the P-type doped polysilicon layer is greater than 0 and less than or equal to 0.2, the extinction coefficient k of the N-type doped polysilicon layer is greater than the extinction coefficient k of the P-type doped polysilicon layer, so that the extinction coefficient k of the N-type doped polysilicon layer is also greater than the extinction coefficient k of the P-type doped polysilicon layer in the solar cell manufactured based on the semiconductor structure provided in this embodiment of the present application. For beneficial effects when the extinction coefficient k of the N-type doped polysilicon layer is also greater than the extinction coefficient k of the P-type doped polysilicon layer in the solar cell, reference may be made to the foregoing description, and details are not described herein.

For beneficial effects of the second aspect and various implementations of the second aspect in the embodiments of the present application, reference may be made to the analysis of the beneficial effects of the first aspect and various implementations of the first aspect, and details are not described herein.

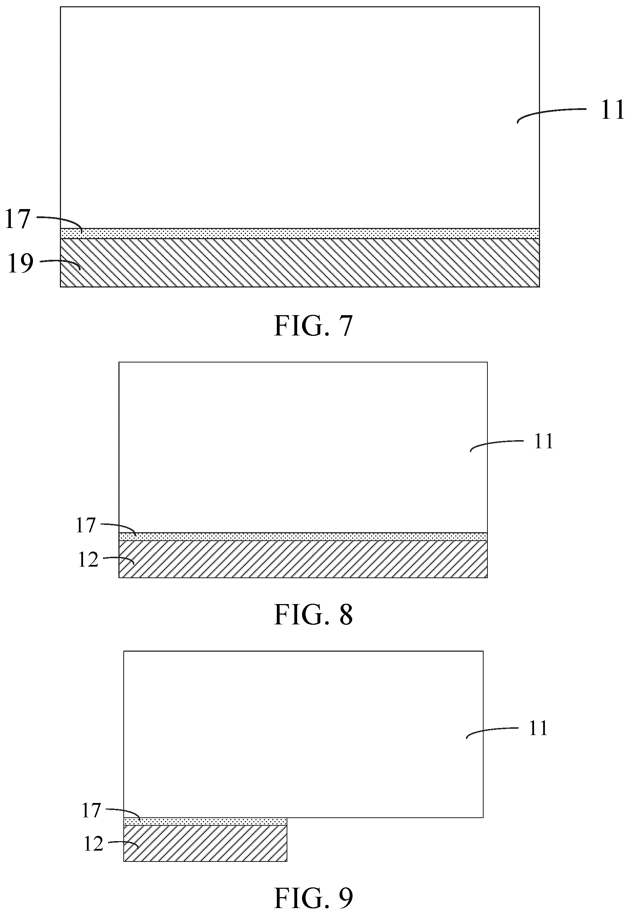

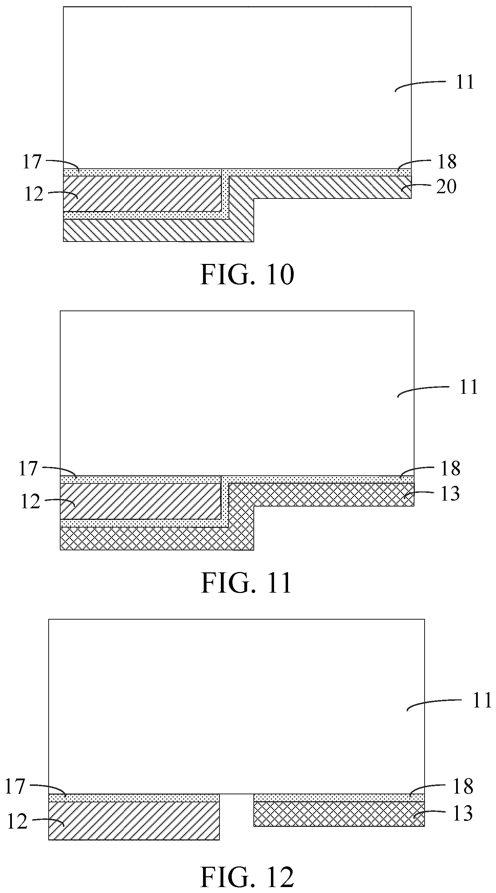

According to a third aspect, an embodiment of the present application provides a manufacturing method of a solar cell. The manufacturing method of a solar cell includes the following steps: providing a semiconductor substrate, where the semiconductor substrate includes a first region and a second region; and the first region and the second region are located on the same surface of the semiconductor substrate, or the first region and the second region are respectively located on two opposite surfaces of the semiconductor substrate; as shown in FIG. 9, forming a P-type doped polysilicon layer 12 at least on the first region; and as shown in FIG. 12, forming an N-type doped polysilicon layer 13 at least on the second region, where at least a portion of the N-type doped polysilicon layer 13 is spaced apart from at least a portion of the P-type doped polysilicon layer 12; a ratio of a refractive index n of the N-type doped polysilicon layer 13 to a refractive index n of the P-type doped polysilicon layer 12 is greater than or equal to 0.9 and less than or equal to 1.1; and/or an absolute value of a difference value between the refractive index n of the P-type doped polysilicon layer 12 and the refractive index n of the N-type doped polysilicon layer 13 is greater than or equal to 0 and less than or equal to 0. 1.

For beneficial effects of the third aspect in the embodiments of the present application, reference may be made to the analysis of the beneficial effects of the first aspect and various implements of the first aspect, and details are not described herein.

In an actual application process, for a material of the semiconductor substrate, ranges of the first region and the second region, and related information of the N-type doped polysilicon layer and the P-type doped polysilicon layer, reference may be made to the foregoing description, and details are not described herein again. A formation process of the P-type doped polysilicon layer and the N-type doped polysilicon layer may be determined according to a type of the manufactured solar cell.

For example, in a case that the first region and the second region are located on the same surface of the semiconductor substrate, when a formation sequence of the N-type doped polysilicon layer is after a formation sequence of the P-type doped polysilicon layer, the forming a P-type doped polysilicon layer at least on the first region may include steps: as shown in FIG. 7, forming a first intrinsic polysilicon layer 19 covering the first region and the second region; as shown in FIG. 8, performing diffusion treatment on the first intrinsic polysilicon layer, to form the first intrinsic polysilicon layer into the P-type doped polysilicon layer 12; and as shown in FIG. 9, selectively removing a part of the P-type doped polysilicon layer 12 located on at least a part of the second region.

Specifically, in an actual application process, the first intrinsic polysilicon layer may be formed through a process such as chemical vapor deposition. After the P-type doped polysilicon layer arranged as a whole is obtained by performing diffusion treatment of P-type impurities such as boron atoms on the first intrinsic polysilicon layer, selective heat treatment may be performed on a doped silicate glass layer formed on the P-type doped polysilicon layer in a laser irradiation manner, so that a structure of a part of the doped silicate glass layer on the second region is looser. Next, the part of the P-type doped polysilicon layer located on at least a part of the second region may be selectively removed by using a part of the doped silicate glass layer located on the first region as a mask. In a case that the corresponding surface of the semiconductor substrate includes only the first region and the second region, the part of the P-type doped polysilicon layer located on the second region may be totally removed, or only the part of the P-type doped polysilicon layer located on a part of the second region may be removed to reduce a hot spot risk of the manufactured solar cell. In addition, in a case that the corresponding surface of the semiconductor substrate includes the first region, the second region, and the isolation region, the part of the P-type doped polysilicon layer located on the second region and/or the isolation region may be totally removed, or only the part of the P-type doped polysilicon layer located on a part of the second region and/or a part of the isolation region may be removed to reduce a hot spot risk of the manufactured solar cell.

In an actual manufacturing process, in a case that the first region and the second region are located on the same surface of the semiconductor substrate, when the formation sequence of the N-type doped polysilicon layer is located before the formation sequence of the P-type doped polysilicon layer, the forming a P-type doped polysilicon layer at least on the first region may include steps: forming a first intrinsic polysilicon layer at least covering the N-type doped polysilicon layer and the first region; performing diffusion treatment on the first intrinsic polysilicon layer, to form the first intrinsic polysilicon layer into the P-type doped polysilicon layer; and selectively removing a part of the P-type doped polysilicon layer located on at least a part of the N-type doped polysilicon layer. In this case, for a specific formation process of the P-type doped polysilicon layer, reference may be made to the specific formation process of the P-type doped polysilicon layer when the formation sequence of the N-type doped polysilicon layer is located after the formation sequence of the P-type doped polysilicon layer described above, and details are not described herein.

For example, in a case that the first region and the second region are respectively located on two opposite surfaces of the semiconductor substrate, the forming a P-type doped polysilicon layer at least on the first region may include steps: forming a first intrinsic polysilicon layer at least covering the first region; and performing diffusion treatment on the first intrinsic polysilicon layer, to form the first intrinsic polysilicon layer into the P-type doped polysilicon layer. Specifically, the first intrinsic polysilicon layer may be formed through a process such as chemical vapor deposition. A P-type doped polysilicon layer arranged as a whole is then obtained by performing diffusion treatment of P-type impurities such as boron atoms on the first intrinsic polysilicon layer.

Specifically, in an actual manufacturing process, no matter the first region and the second region are located on the same surface of the semiconductor substrate or the first region and the second region are respectively located on two opposite surfaces of the semiconductor substrate, the P-type doped polysilicon layer formed at least on the first region may be formed by diffusing boron impurities into the first intrinsic polysilicon layer. Boron atoms have a relatively small size, and a corresponding diffusion manner is interstitial diffusion. Compared with substitutional diffusion, it is more difficult to control the interstitial diffusion. A thickness, an extinction coefficient k, and a refractive index n of the first intrinsic polysilicon layer affect a doping depth and doping difficulty of impurities in the first intrinsic polysilicon layer. Based on this, the thickness, the extinction coefficient k, and the refractive index n of the first intrinsic polysilicon layer may be determined according to a doping situation of the P-type doped polysilicon layer in an actual application scenario.

In an embodiment, a ratio of the thickness of the first intrinsic polysilicon layer to a thickness of the P-type doped polysilicon layer may be greater than or equal to 1.4 and less than or equal to 1.5. For example, the ratio of the thickness of the first intrinsic polysilicon layer to the thickness of the P-type doped polysilicon layer may be 1.4, 1.42, 1.44, 1.46, 1.48, or 1.5.

In an embodiment, a difference value between the thickness of the first intrinsic polysilicon layer and the thickness of the P-type doped polysilicon layer may be greater than or equal to 100 nm and less than or equal to 130 nm. For example, the difference value between the thickness of the first intrinsic polysilicon layer and the thickness of the P-type doped polysilicon layer may be 100 nm, 105 nm, 110 nm, 115 nm, 120 nm, 125 nm, or 130 nm.

In an embodiment, the extinction coefficient k of the first intrinsic polysilicon layer may be less than an extinction coefficient k of the P-type doped polysilicon layer. In this case, a density of the first intrinsic polysilicon layer is higher than that of the P-type doped polysilicon layer, which is conducive to preventing a problem of extending through or a large internal extension range since impurities pass through the first intrinsic polysilicon layer and enter the semiconductor substrate when diffusion treatment is performed on the first intrinsic polysilicon layer, thereby ensuring that the solar cell has a high open-circuit voltage and fill factor.

For example, an absolute value of a difference value between the extinction coefficient k of the first intrinsic polysilicon layer and the extinction coefficient k of the P-type doped polysilicon layer may be greater than or equal to 0.05, 0.055, 0.06, 0.065, 0.07, 0.075, or 0.08.

In an embodiment, a refractive index n of the first intrinsic polysilicon layer may be greater than or equal to the refractive index n of the P-type doped polysilicon layer. In this case, the refractive index n of the first intrinsic polysilicon layer and the refractive index n of the P-type doped polysilicon layer are related to densities of the film layers. Within a specific range, the refractive index n of the first intrinsic polysilicon layer and the refractive index n of the P-type doped polysilicon layer are positively proportional to the densities of the film layers. Based on this, when the refractive index n of the first intrinsic polysilicon layer is greater than or equal to the refractive index n of the P-type doped polysilicon layer, the first intrinsic polysilicon layer is relatively dense, which is conducive to preventing a problem of extending through or a large internal extension range since impurities pass through the first intrinsic polysilicon layer and enter the semiconductor substrate when diffusion treatment is performed on the first intrinsic polysilicon layer, thereby ensuring that the solar cell has a high open-circuit voltage and fill factor.

For example, a difference value between the refractive index n of the first intrinsic polysilicon layer and the refractive index n of the P-type doped polysilicon layer may be greater than or equal to 0 and less than or equal to 0.1. For example, the difference value between the refractive index n of the first intrinsic polysilicon layer and the refractive index n of the P-type doped polysilicon layer may be 0, 0.01, 0.02, 0.04, 0.06, 0.08, or 0.1.

In addition, in an actual manufacturing process, in a case that the first region and the second region are located on the same surface of the semiconductor substrate, when the formation sequence of the N-type doped polysilicon layer is located after the formation sequence of the P-type doped polysilicon layer, the forming an N-type doped polysilicon layer at least on the second region may include: as shown in FIG. 10, forming a second intrinsic polysilicon layer 20 at least covering the P-type doped polysilicon layer and the second region; as shown in FIG. 11, performing diffusion treatment on the second intrinsic polysilicon layer, to form the second intrinsic polysilicon layer into the N-type doped polysilicon layer 13; and as shown in FIG. 12, selectively removing a part of the N-type doped polysilicon layer 13 located on at least a part of the P-type doped polysilicon layer.

For example, the second intrinsic polysilicon layer may be formed through a process such as chemical vapor deposition. When the corresponding surface of the semiconductor substrate includes only the first region and the second region, the second intrinsic polysilicon layer covers only the P-type doped polysilicon layer and the second region. When the corresponding surface of the semiconductor substrate not only includes the first region and the second region but further includes an isolation region, the second intrinsic polysilicon layer covers the P-type doped polysilicon layer, the second region, and the isolation region. Diffusion treatment of N-type impurities such as phosphorus atoms is then performed on the second intrinsic polysilicon layer to form the N-type doped polysilicon layer. Then, selective heat treatment may be performed on a doped silicate glass layer formed on the N-type doped polysilicon layer in a laser irradiation manner, so that a structure of a part of the doped silicate glass layer located on at least a part of the P-type doped polysilicon layer (or may be a part of the doped silicate glass layer located on each region of the P-type doped polysilicon layer, or may be a part of the doped silicate glass layer located on a part of the P-type doped polysilicon layer to reduce a hot spot risk of the manufactured solar cell, and in a case that the corresponding surface of the semiconductor substrate further includes the isolation region, may be a part of the doped silicate glass layer located on each region of the P-type doped polysilicon layer and the isolation region, or may be a part of the doped silicate glass layer located on a part of the P-type doped polysilicon layer and/or a part of the isolation region to reduce a hot spot risk of the manufactured solar cell) is looser. Next, the part of the N-type doped polysilicon layer located on at least a part of the P-type doped polysilicon layer may be selectively removed by using a part of the doped silicate glass layer located at least on the second region as a mask.

In an actual manufacturing process, in a case that the first region and the second region are located on the same surface of the semiconductor substrate, when the formation sequence of the N-type doped polysilicon layer is located before the formation sequence of the P-type doped polysilicon layer, the forming an N-type doped polysilicon layer at least on the second region may include steps: forming a second intrinsic polysilicon layer covering the first region and the second region; performing diffusion treatment on the second intrinsic polysilicon layer, to form the second intrinsic polysilicon layer into the N-type doped polysilicon layer; and selectively removing a part of the N-type doped polysilicon layer located on at least a part of the first region. In this case, for a formation process of the N-type doped polysilicon layer, reference may be made to the formation process of the N-type doped polysilicon layer when the formation sequence of the N-type doped polysilicon layer is located after the formation sequence of the P-type doped polysilicon layer described above, and details are not described herein.

In a case that the first region and the second region are respectively located on two opposite surfaces of the semiconductor substrate, the forming an N-type doped polysilicon layer at least on the second region may include: forming a second intrinsic polysilicon layer at least covering the first region and the second region; and performing diffusion treatment on the second intrinsic polysilicon layer, to form the second intrinsic polysilicon layer into the N-type doped polysilicon layer. Specifically, the second intrinsic polysilicon layer may be formed through a process such as chemical vapor deposition. Diffusion treatment of N-type impurities such as phosphorus atoms is then performed on the second intrinsic polysilicon layer to form the N-type doped polysilicon layer.

Specifically, in an actual manufacturing process, in a case that the first region and the second region are respectively located on two opposite surfaces of the semiconductor substrate, the formation sequence of the N-type doped polysilicon layer may be located before the formation sequence of the P-type doped polysilicon layer or may be located after the formation sequence of the P-type doped polysilicon layer. The formation sequence of the N-type doped polysilicon layer and the formation sequence of the P-type doped polysilicon layer are not specifically limited in the embodiments of the present application. In a case that the first region and the second region are respectively located on two opposite surfaces of the semiconductor substrate, for a formation process of the N-type doped polysilicon layer and a formation process of the P-type doped polysilicon layer, reference may be made to the foregoing description. In this case, if at least one of the N-type doped polysilicon layer and the P-type doped polysilicon layer is formed in a portion of the corresponding surface, after a doped semiconductor layer of a corresponding conductivity type is formed, a mask layer (for example, a doped silicate glass layer) further needs to be formed in a portion of the doped semiconductor layer through laser and etching processes, and patterning processing is then performed on the doped semiconductor layer under protection effect of the mask layer, to obtain the doped semiconductor layer located only in a portion of the corresponding surface.

In addition, a thickness, an extinction coefficient k, and a refractive index n of the second intrinsic polysilicon layer affect a doping depth and doping difficulty of impurities in the second intrinsic polysilicon layer. Based on this, the thickness, the extinction coefficient k, and the refractive index n of the second intrinsic polysilicon layer may be determined according to a doping situation of the N-type doped polysilicon layer in an actual application scenario.

For example, a ratio of the thickness of the second intrinsic polysilicon layer to a thickness of the N-type doped polysilicon layer may be greater than or equal to 1.1 and less than or equal to 1.3. For example, the ratio of the thickness of the second intrinsic polysilicon layer to the thickness of the N-type doped polysilicon layer may be 1.1, 1.12, 1.15, 1.19, 1.2, 1.25, 1.28, or 1.3.

For example, a difference value between the thickness of the second intrinsic polysilicon layer and the thickness of the N-type doped polysilicon layer may be greater than or equal to 40 nm and less than or equal to 60 nm. For example, the difference value between the thickness of the second intrinsic polysilicon layer and the thickness of the N-type doped polysilicon layer may be 40 nm, 45 nm, 50 nm, 55 nm, 58 nm, or 60 nm.

In an embodiment, a refractive index n of the second intrinsic polysilicon layer may be less than the refractive index n of the N-type doped polysilicon layer. In this case, the refractive index n of the second intrinsic polysilicon layer and the refractive index n of the N-type doped polysilicon layer are also related to densities of the film layers. Within a specific range, the refractive index n of the second intrinsic polysilicon layer and the refractive index n of the N-type doped polysilicon layer are positively proportional to the densities of the film layers. In this case, when the refractive index n of the second intrinsic polysilicon layer is less than the refractive index n of the N-type doped polysilicon layer, before the diffusion treatment, the second intrinsic polysilicon layer has a relatively low density, which is conducive to doping N-type impurities into the second intrinsic polysilicon layer. After the diffusion treatment, the density of the N-type doped polysilicon layer is increased, which is conducive to preventing the electrode slurry for manufacturing the negative electrodes from penetrating the N-type doped polysilicon layer and reducing a metal recombination area between the N-type doped polysilicon layer and the negative electrodes, thereby reducing a metal recombination loss.

For example, a difference value between the refractive index n of the second intrinsic polysilicon layer and the refractive index n of the N-type doped polysilicon layer may be greater than or equal to -0.09 and less than or equal to -0.05. For example, the difference value between the refractive index n of the second intrinsic polysilicon layer and the refractive index n of the N-type doped polysilicon layer may be -0.09, -0.086, -0.08, -0.07, -0.065, -0.06, or -0.05.

For example, the extinction coefficient k of the second intrinsic polysilicon layer may be greater than an extinction coefficient k of the N-type doped polysilicon layer. In this case, as described above, within a specific range, the extinction coefficient k of the film layer is inversely proportional to the density of the film layer. Based on this, when the extinction coefficient k of the second intrinsic polysilicon layer is greater than the extinction coefficient k of the N-type doped polysilicon layer, the density of the second intrinsic polysilicon layer is lower than the density of the N-type doped polysilicon layer. For beneficial effects when the density of the second intrinsic polysilicon layer is lower than the density of the N-type doped polysilicon layer, reference may be made to the foregoing description, and details are not described herein.

For example, a difference value between the extinction coefficient k of the second intrinsic polysilicon layer and the extinction coefficient k of the N-type doped polysilicon layer may be greater than or equal to 0.08 and less than or equal to 0.23. For example, the difference value between the extinction coefficient k of the second intrinsic polysilicon layer and the extinction coefficient k of the N-type doped polysilicon layer may be 0.08, 0.09, 0.10, 0.11, 0.12, 0.13, 0.14, 0.15, 0.16, 0.17, 0.18, 0.19, 0.20, 0.21, 0.22, or 0.23.

A relationship between the thicknesses, the extinction coefficients k, and the refractive indexes n of the second intrinsic polysilicon layer and the first intrinsic polysilicon layer may be determined according to a relationship between the thicknesses, the refractive indexes n, and the extinction coefficients k of the P-type doped polysilicon layer and the N-type doped polysilicon layer, a relationship between the thicknesses, the refractive indexes n, and the extinction coefficients k of the first intrinsic polysilicon layer and the P-type doped polysilicon layer, and a relationship between the thicknesses, the refractive indexes n, and the extinction coefficients k of the second intrinsic polysilicon layer and the N-type doped polysilicon layer, which is not specifically limited herein.

For example, the thickness of the second intrinsic polysilicon layer may be less than the thickness of the first intrinsic polysilicon layer. In this case, as described above, a film layer etching capability of the electrode slurry for manufacturing the positive electrodes is greater than a film layer etching capability of the electrode slurry for manufacturing the negative electrodes. The first intrinsic polysilicon layer is configured for manufacturing the P-type doped polysilicon layer, and the second intrinsic polysilicon layer is configured for manufacturing the N-type doped polysilicon layer. In the foregoing case, when the thickness of the second intrinsic polysilicon layer is less than the thickness of the first intrinsic polysilicon layer, a thickness of the P-type doped polysilicon layer formed based on the first intrinsic polysilicon layer with a greater thickness is increased, so that a risk that the electrode slurry for manufacturing the positive electrodes penetrates the P-type doped polysilicon layer is further reduced, thereby ensuring that the P-type doped polysilicon layer has a relatively high field passivation effect and preventing the electrode slurry for manufacturing the positive electrodes from causing damage to the semiconductor substrate.

For example, a ratio of the thickness of the second intrinsic polysilicon layer to the thickness of the first intrinsic polysilicon layer may be greater than or equal to 0.55 and less than or equal to 0.8; and/or a difference value between the thickness of the second intrinsic polysilicon layer and the thickness of the first intrinsic polysilicon layer may be greater than or equal to -140 nm and less than or equal to -100 nm.

For example, the ratio of the thickness of the second intrinsic polysilicon layer to the thickness of the first intrinsic polysilicon layer may be 0.55, 0.56, 0.58, 0.6, 0.65, 0.7, 0.75, or 0.8. For example, the difference value between the thickness of the second intrinsic polysilicon layer and the thickness of the first intrinsic polysilicon layer may be -140 nm, -135 nm, -130 nm, -125 nm, -120 nm, -110 nm, or -100 nm.

In a case that the foregoing technical solution is used, the ratio of the thickness of the second intrinsic polysilicon layer to the thickness of the first intrinsic polysilicon layer falls within the foregoing range, so that a small thickness of the second intrinsic polysilicon layer and/or a large thickness of the first intrinsic polysilicon layer caused by a small ratio may be prevented; and a large thickness of the second intrinsic polysilicon layer and/or a small thickness of the first intrinsic polysilicon layer caused by a large ratio may also be prevented. Based on the above, the ratio of the thickness of the second intrinsic polysilicon layer to the thickness of the first intrinsic polysilicon layer falls within the foregoing range, which is conducive to properly setting the thickness of the first intrinsic polysilicon layer and the thickness of the second intrinsic polysilicon layer, thereby ensuring that problems such as extending through or a large internal extension range do not occur after the diffusion treatment. In addition, the P-type doped polysilicon layer and the N-type doped polysilicon layer respectively have a high matching degree with the electrode slurry for manufacturing the positive electrodes and the electrode slurry for manufacturing the negative electrodes, thereby ensuring that the P-type doped polysilicon layer and the N-type doped polysilicon layer each have a relatively high field passivation effect.

For example, the refractive index n of the second intrinsic polysilicon layer may be less than the refractive index n of the first intrinsic polysilicon layer. In this case, as described above, within a specific range, the refractive index n of the film layer is positively proportional to the density of the film layer. Based on this, when the refractive index n of the second intrinsic polysilicon layer is less than the refractive index n of the first intrinsic polysilicon layer, the first intrinsic polysilicon layer has a relatively high film layer density, which is conducive to preventing P-type impurities such as boron atoms with a small size from extending through the first intrinsic polysilicon layer. In addition, N-type impurities such as phosphorus with a large size are doped into the second intrinsic polysilicon layer in a substitutional diffusion manner. In the substitutional diffusion manner, semiconductor atoms are replaced with impurity atoms to form a doped region, so that when the density of the second intrinsic polysilicon layer is relatively low, diffusion of the N-type impurities such as phosphorus with a large size is implemented, and the diffusion difficulty is reduced, which is conducive to improving a doping concentration of impurities in the N-type doped polysilicon layer.

For example, a difference value between the refractive index n of the second intrinsic polysilicon layer and the refractive index n of the first intrinsic polysilicon layer may be greater than or equal to -0.12 and less than or equal to -0.1. For example, a ratio of the refractive index n of the second intrinsic polysilicon layer to the refractive index n of the first intrinsic polysilicon layer may be -0.12, -0.118, -0.116, -0.114, -0.112, or -0.1.

For example, the extinction coefficient k of the second intrinsic polysilicon layer is greater than the extinction coefficient k of the first intrinsic polysilicon layer. In this case, the density of the second intrinsic polysilicon layer is lower than the density of the first intrinsic polysilicon layer. For beneficial effects in this case, reference may be made to the beneficial effects when the refractive index n of the second intrinsic polysilicon layer is less than the refractive index n of the first intrinsic polysilicon layer described above, and details are not described herein.

For example, a difference value between the extinction coefficient k of the second intrinsic polysilicon layer and the extinction coefficient k of the first intrinsic polysilicon layer may be greater than or equal to 0.02 and less than or equal to 0.3. For example, the difference value between the extinction coefficient k of the second intrinsic polysilicon layer and the extinction coefficient k of the first intrinsic polysilicon layer may be 0.02, 0.022, 0.024, 0.026, 0.028, 0.03, 0.034, 0.038, 0.04, 0.08, 0.1, 0.12, 0.15, 0.18, 0.2, 0.22, 0.25, 0.28, or 0.3.

In addition, in an actual manufacturing process, the density and a formation thickness of the film layer may be effected by a formation temperature, a formation time, and a diffusion temperature of the film layer, so that film layer features of the first intrinsic polysilicon layer, the second intrinsic polysilicon layer, the P-type doped polysilicon layer, and the N-type doped polysilicon layer may be regulated by adjusting the foregoing parameters.

For example, a formation temperature of the second intrinsic polysilicon layer may be greater than a formation temperature of the first intrinsic polysilicon layer. In this case, while other factors are the same, a higher formation temperature indicates a faster deposition rate. Based on this, when the formation temperature of the second intrinsic polysilicon layer is greater than the formation temperature of the first intrinsic polysilicon layer, the second intrinsic polysilicon layer has a relatively fast material deposition rate and a relatively low corresponding film layer density, which is conducive to obtaining a second intrinsic polysilicon layer with a loose structure and a first intrinsic polysilicon layer with a dense structure, further reducing the N-type impurities such as phosphorus with a large size doped into the second intrinsic polysilicon layer in the substitutional diffusion manner, and also preventing a problem of extending through or a large internal extension range after the P-type impurities such as boron atoms with a small size are doped into the first intrinsic polysilicon layer in an interstitial diffusion manner.

For example, a formation time of the second intrinsic polysilicon layer may be less than a formation time of the first intrinsic polysilicon layer. In this case, while other factors are the same, a longer formation time indicates a thicker film layer. Based on this, when the formation time of the second intrinsic polysilicon layer is less than the formation time of the first intrinsic polysilicon layer, the first intrinsic polysilicon layer has a larger film layer thickness, further preventing the problem of extending through or a large internal extension range after diffusion.

For example, a temperature of the diffusion treatment on the first intrinsic polysilicon layer may be greater than a temperature of the diffusion treatment on the second intrinsic polysilicon layer. In this case, P-type impurities such as boron atoms can be diffused into the first intrinsic polysilicon layer in an interstitial diffusion manner, so that the diffusion difficulty is reduced, and a doping concentration of impurities in the P-type doped polysilicon layer is improved.

Specific values of process parameters for forming the first intrinsic polysilicon layer and the second intrinsic polysilicon layer during the diffusion treatment may be determined according to an actual application scenario, which are not specifically limited herein.

It should be noted that, in a case that the first region and the second region are located on the same surface of the semiconductor substrate, when the formation sequence of the P-type doped polysilicon layer is located before the formation sequence of the N-type doped polysilicon layer: the step of forming a first intrinsic polysilicon layer covering the first region and the second region specifically at least includes the following two cases: in the first case, the first intrinsic polysilicon layer for manufacturing the P-type doped polysilicon layer is directly formed on the surface in which the first region and the second region of the semiconductor substrate are located; or in the second case, in a case that the manufactured solar cell further includes a first tunneling passivation layer, the first tunneling passivation layer is formed on the surface in which the first region and the second region of the semiconductor substrate are located or the surface in which the first region and the second region of the semiconductor substrate are located is oxidized to form the first tunneling passivation layer, and the first intrinsic polysilicon layer is formed on the first tunneling passivation layer. In this case, after the first intrinsic polysilicon layer is formed, the first tunneling passivation layer and the first intrinsic polysilicon layer are stacked on the first region and the second region along the thickness direction of the semiconductor substrate. In addition, patterning processing may be performed on the whole first tunneling passivation layer before the first intrinsic polysilicon layer is formed, or patterning processing may be performed on the whole first tunneling passivation layer while the P-type doped polysilicon layer is selectively removed after the P-type doped polysilicon layer is formed, to only reserve a part of the first tunneling passivation layer located between the P-type doped polysilicon layer and the semiconductor substrate. Specifically, the first tunneling passivation layer may be formed on the first region and the second region of the semiconductor substrate through a process such as chemical vapor deposition or thermal oxidation. In addition, the step of forming a second intrinsic polysilicon layer at least covering the P-type doped polysilicon layer and the second region may specifically at least include the following cases: in the first case, the second intrinsic polysilicon layer for manufacturing the N-type doped polysilicon layer may be directly formed on a surface of the second region of the semiconductor substrate and a surface of the P-type doped polysilicon layer away from the semiconductor substrate; or in the second case, in a case that the manufactured solar cell further includes a second tunneling passivation layer or an insulating mask layer, the insulating mask layer or the second tunneling passivation layer is formed on the surface of the second region of the semiconductor substrate and the surface of the P-type doped polysilicon layer away from the semiconductor substrate, and the second intrinsic polysilicon layer is formed on the second tunneling passivation layer or a surface of the insulating mask layer facing away from the semiconductor substrate; and after the second intrinsic polysilicon layer is formed, the insulating mask layer or the second tunneling passivation layer and the second intrinsic polysilicon layer are stacked on the P-type doped polysilicon layer and the second region along the thickness direction of the semiconductor substrate; or in the third case, in a case that the manufactured solar cell further includes an insulating mask layer and a second tunneling passivation layer, the insulating mask layer and the second tunneling passivation layer are sequentially formed on a surface of the second region of the semiconductor substrate and a surface of the P-type doped polysilicon layer away from the semiconductor substrate, the second tunneling passivation layer is formed on a side of the insulating mask layer facing away from the semiconductor substrate, and the second intrinsic polysilicon layer is formed on a surface of the second tunneling passivation layer facing away from the semiconductor substrate; and after the second intrinsic polysilicon layer is formed, the insulating mask layer, the second tunneling passivation layer, and the second intrinsic polysilicon layer are stacked on the P-type doped polysilicon layer and the second region along the thickness direction of the semiconductor substrate. The insulating mask layer may be independently prepared, or may be formed when diffusion is performed on the P-type doped polysilicon layer and obtained through laser irradiation and an etching process. For a formation process of the second tunneling passivation layer, reference may be made to the formation process of the first tunneling passivation layer described above, and details are not described herein.

The following is described by using an example in which the solar cell further includes a first tunneling passivation layer: the first tunneling passivation layer needs to be formed on the first region and the second region before the first intrinsic polysilicon layer is formed; and the first intrinsic polysilicon layer is then formed on a side of the first tunneling passivation layer facing away from the semiconductor substrate. In this case, after the first intrinsic polysilicon layer is formed, the first tunneling passivation layer and the first intrinsic polysilicon layer are stacked on the first region and the second region along the thickness direction of the semiconductor substrate. Specifically, the first tunneling passivation layer may be formed on the first region and the second region of the semiconductor substrate through a process such as chemical vapor deposition or thermal oxidation.

In a case that the first region and the second region are located on the same surface of the semiconductor substrate, when the formation sequence of the N-type doped polysilicon layer is located before the formation sequence of the P-type doped polysilicon layer, the step of forming a second intrinsic polysilicon layer covering the first region and the second region specifically at least includes the following two cases: in the first case, the second intrinsic polysilicon layer for manufacturing the N-type doped polysilicon layer is directly formed on the surface in which the first region and the second region of the semiconductor substrate are located; or in the second case, in a case that the manufactured solar cell further includes a second tunneling passivation layer, the second tunneling passivation layer is formed on the surface in which the first region and the second region of the semiconductor substrate are located or the surface in which the first region and the second region of the semiconductor substrate are located is oxidized to form the second tunneling passivation layer, and the second intrinsic polysilicon layer is formed on the second tunneling passivation layer. In this case, after the second intrinsic polysilicon layer is formed, the second tunneling passivation layer and the second intrinsic polysilicon layer are stacked on the first region and the second region along the thickness direction of the semiconductor substrate. In addition, patterning processing may be performed on the whole second tunneling passivation layer before the second intrinsic polysilicon layer is formed, or patterning processing may be performed on the whole second tunneling passivation layer while the N-type doped polysilicon layer is selectively removed after the N-type doped polysilicon layer is formed, to only reserve a part of the second tunneling passivation layer located between the N-type doped polysilicon layer and the semiconductor substrate. Specifically, the second tunneling passivation layer may be formed on the first region and the second region of the semiconductor substrate through a process such as chemical vapor deposition or thermal oxidation. In addition, the step of forming a second intrinsic polysilicon layer at least covering the P-type doped polysilicon layer and the second region may specifically at least include the following three cases: in the first case, the second intrinsic polysilicon layer for manufacturing the N-type doped polysilicon layer may be directly formed on a surface of the second region of the semiconductor substrate and a surface of the P-type doped polysilicon layer away from the semiconductor substrate; or in the second case, in a case that the manufactured solar cell further includes a second tunneling passivation layer or an insulating mask layer, the insulating mask layer or the second tunneling passivation layer is formed on a surface of the second region of the semiconductor substrate and a surface of the P-type doped polysilicon layer away from the semiconductor substrate; and the second intrinsic polysilicon layer is then formed on a surface of the second tunneling passivation layer or the insulating mask layer facing away from the semiconductor substrate, and after the second intrinsic polysilicon layer is formed in this case, the insulating mask layer or the second tunneling passivation layer and the second intrinsic polysilicon layer are stacked on the P-type doped polysilicon layer and the second region of the semiconductor substrate along the thickness direction of the semiconductor substrate; or in the third case, in a case that the manufactured solar cell further includes an insulating mask layer and a second tunneling passivation layer, the insulating mask layer and the second tunneling passivation layer are sequentially formed on a surface of the second region of the semiconductor substrate and a surface of the P-type doped polysilicon layer away from the semiconductor substrate, and the second tunneling passivation layer is formed on a side of the insulating mask layer facing away from the semiconductor substrate; and the second intrinsic polysilicon layer is then formed on a surface of the second tunneling passivation layer facing away from the semiconductor substrate, and after the second intrinsic polysilicon layer is formed, the insulating mask layer, the second tunneling passivation layer, and the first intrinsic polysilicon layer are stacked on the P-type doped polysilicon layer and the second region along the thickness direction of the semiconductor substrate.

The following is described by using an example in which the solar cell further includes a second tunneling passivation layer: the second tunneling passivation layer needs to be formed on the second region and the P-type doped polysilicon layer before the second intrinsic polysilicon layer is formed; and the second intrinsic polysilicon layer is then formed on the second tunneling passivation layer. In this case, after the second intrinsic polysilicon layer is formed, the second tunneling passivation layer and the second intrinsic polysilicon layer are stacked on the second region and the P-type doped polysilicon layer along the thickness direction of the semiconductor substrate. Specifically, the second tunneling passivation layer may be formed on the second region of the semiconductor substrate and the P-type doped polysilicon layer through a process such as chemical vapor deposition or thermal oxidation.

In a case that the first region and the second region are located on two opposite surfaces of the semiconductor substrate, the step of forming a first intrinsic polysilicon layer on the first region specifically at least includes the following cases: in the first case, the first intrinsic polysilicon layer for manufacturing the P-type doped polysilicon layer is directly formed on a surface in which the first region of the semiconductor substrate is located, and/or the second intrinsic polysilicon layer for manufacturing the N-type doped polysilicon layer is directly formed on a surface in which the second region of the semiconductor substrate is located; or in the second case, in a case that the manufactured solar cell further includes a first tunneling passivation layer, the first tunneling passivation layer is formed on a surface in which the first region of the semiconductor substrate is located or the surface in which the first region of the semiconductor substrate is located is oxidized to form the first tunneling passivation layer, and the first intrinsic polysilicon layer is formed on the first tunneling passivation layer; and/or in a case that the manufactured solar cell further includes a second tunneling passivation layer, the second tunneling passivation layer is formed on a surface in which the second region of the semiconductor substrate is located or a surface in which the second region of the semiconductor substrate is located is oxidized to form the second tunneling passivation layer, and the second intrinsic polysilicon layer is formed on the second tunneling passivation layer. In this case, when the first tunneling passivation layer exists, after the first intrinsic polysilicon layer is formed, the first tunneling passivation layer and the first intrinsic polysilicon layer are stacked on the first region along the thickness direction of the semiconductor substrate; and when the second tunneling passivation layer exists, after the second intrinsic polysilicon layer is formed, the second tunneling passivation layer and the second intrinsic polysilicon layer are stacked on the second region along the thickness direction of the semiconductor substrate.

In an example, after the forming a P-type doped polysilicon layer at least on the first region and the forming an N-type doped polysilicon layer at least on the second region (that is, after the semiconductor structure is formed), the manufacturing method of a solar cell further includes a step: as shown in FIG. 13, performing passivation treatment at least on a side of the P-type doped polysilicon layer 12 facing away from the semiconductor substrate 11 and a side of N-type doped polysilicon layer 13 facing away from the semiconductor substrate 11, to form a surface passivation layer 14 at least covering the side of the P-type doped polysilicon layer 12 facing away from the semiconductor substrate 11 and the side of the N-type doped polysilicon layer 13 facing away from the semiconductor substrate 11. After the passivation treatment, a ratio of the extinction coefficient k of the N-type doped polysilicon layer 13 to the extinction coefficient k of the P-type doped polysilicon layer 12 is greater than or equal to 1.5 and less than or equal to 2.5.

In a case that the first region and the second region are located on two opposite surfaces of the semiconductor substrate, when each of the first region and the second region is arranged as a whole on the corresponding surface, passivation treatment may be performed on only the side of the P-type doped polysilicon layer facing away from the semiconductor substrate and the side of the N-type doped polysilicon layer facing away from the semiconductor substrate; and when the first region and/or the second region is only partially arranged on the corresponding surface, passivation treatment may also be performed on a region of the corresponding surface of the semiconductor substrate exposed outside the P-type doped polysilicon layer and the N-type doped polysilicon layer while passivation treatment is performed on the side of the P-type doped polysilicon layer facing away from the semiconductor substrate and the side of the N-type doped polysilicon layer facing away from the semiconductor substrate. In a case that the first region and the second region are located on the same surface of the semiconductor substrate, when the corresponding surface includes only the first region and the second region, passivation treatment may be performed only on the side of the P-type doped polysilicon layer facing away from the semiconductor substrate and the side of the N-type doped polysilicon layer facing away from the semiconductor substrate; and when the corresponding surface includes the first region, the second region, and the isolation region, passivation treatment may also be performed on a surface of the isolation region while passivation treatment is performed on the side of the P-type doped polysilicon layer facing away from the semiconductor substrate and the side of the N-type doped polysilicon layer facing away from the semiconductor substrate. After the passivation treatment, for extinction coefficients k, refractive indexes n, and thicknesses of the N-type doped polysilicon layer and the P-type doped polysilicon layer, reference may be made to the foregoing description, and details are not described herein.

In addition, a relationship between thicknesses, extinction coefficients k, and refractive indexes n of the P-type doped polysilicon layer after the passivation treatment and the P-type doped polysilicon layer before the passivation treatment and a relationship between thicknesses, extinction coefficients k, and refractive indexes n of the N-type doped polysilicon layer after the passivation treatment and the N-type doped polysilicon layer before the passivation treatment may be determined according to process conditions of the passivation treatment, film layer features such as densities of the P-type doped polysilicon layer and the N-type doped polysilicon layer before the passivation treatment, and etching features of electrode slurries for forming the positive electrodes and the negative electrodes subsequently, which are not specifically limited herein.

For example, a ratio of a thickness of the P-type doped polysilicon layer after the passivation treatment to a thickness of the P-type doped polysilicon layer before the passivation treatment may be greater than or equal to 0.95 and less than or equal to 1. For example, the ratio of the thickness of the P-type doped polysilicon layer after the passivation treatment to the thickness of the P-type doped polysilicon layer before the passivation treatment may be 0.95, 0.96, 0.97, 0.98, 0.99, or 1. In this case, the thicknesses of the P-type doped polysilicon layer before and after the passivation treatment are approximately equal, which is conducive to preventing the electrode slurry for manufacturing the negative electrodes from easily penetrating the P-type doped polysilicon layer caused by a large reduction degree of the thickness of the P-type doped polysilicon layer after the passivation treatment, thereby ensuring that the P-type doped polysilicon layer has a high passivation effect.

For example, a ratio of a refractive index n of the P-type doped polysilicon layer after the passivation treatment to a refractive index n of the P-type doped polysilicon layer before the passivation treatment may be greater than or equal to 1 and less than or equal to 1.05. For example, the ratio of the refractive index n of the P-type doped polysilicon layer after the passivation treatment to the refractive index n of the P-type doped polysilicon layer before the passivation treatment may be 1, 1.01, 1.02, 1.03, 1.04, or 1.05.

For example, a ratio of an extinction coefficient k of the P-type doped polysilicon layer after the passivation treatment to an extinction coefficient k of the P-type doped polysilicon layer before the passivation treatment may be greater than or equal to 0.95 and less than or equal to 1. For example, the ratio of the extinction coefficient k of the P-type doped polysilicon layer after the passivation treatment to the extinction coefficient k of the P-type doped polysilicon layer before the passivation treatment may be 0.95, 0.96, 0.97, 0.98, 0.99, or 1.

In a case that the foregoing technical solution is used, when the ratio of the refractive index n of the P-type doped polysilicon layer after the passivation treatment to the refractive index n of the P-type doped polysilicon layer before the passivation treatment is greater than or equal to 1 and less than or equal to 1.05; and/or when the ratio of the extinction coefficient k of the P-type doped polysilicon layer after the passivation treatment to the extinction coefficient k of the P-type doped polysilicon layer before the passivation treatment is greater than or equal to 0.95 and less than or equal to 1, the film layer density of the P-type doped polysilicon layer after the passivation treatment is increased, which is further conductive to preventing the electrode slurry for manufacturing the negative electrodes from penetrating the P-type doped polysilicon layer, thereby ensuring that the P-type doped polysilicon layer has a high passivation effect.

For example, a ratio of a thickness of the N-type doped polysilicon layer after the passivation treatment to a thickness of the N-type doped polysilicon layer before the passivation treatment may be greater than or equal to 0.85 and less than or equal to 0.9. For example, the ratio of the thickness of the N-type doped polysilicon layer after the passivation treatment to the thickness of the N-type doped polysilicon layer before the passivation treatment may be 0.85, 0.86, 0.87, 0.88, 0.89, or 0.9. In this case, the film layer thickness of the N-type doped polysilicon layer is reduced after the passivation treatment, which is conducive to improving the density of the N-type doped polysilicon layer, and preventing the electrode slurry for manufacturing the positive electrodes from penetrating the N-type doped polysilicon layer, thereby ensuring that the N-type doped polysilicon layer has a high passivation effect.

For example, a ratio of a refractive index n of the N-type doped polysilicon layer after the passivation treatment to a refractive index n of the N-type doped polysilicon layer before the passivation treatment may be greater than or equal to 0.3 and less than or equal to 1.1. For example, the ratio of the refractive index n of the N-type doped polysilicon layer after the passivation treatment to the refractive index n of the N-type doped polysilicon layer before the passivation treatment may be 0.3, 0.5, 0.8, 1, 1.02, 1.03, 1.04, 1.06, 1.08, or 1.1.

For example, a ratio of an extinction coefficient k of the N-type doped polysilicon layer after the passivation treatment to an extinction coefficient k of the N-type doped polysilicon layer before the passivation treatment may be greater than or equal to 1.9 and less than or equal to 2.1. For example, the ratio of the extinction coefficient k of the N-type doped polysilicon layer after the passivation treatment to the extinction coefficient k of the N-type doped polysilicon layer before the passivation treatment may be 1.9, 1.92, 1.94, 1.96, 1.98, 2.0, 2.02, 2.04, 2.06, 2.08, or 2.1.

In a case that the foregoing technical solution is used, beneficial effects when the ratio of the refractive index n of the N-type doped polysilicon layer after the passivation treatment to the refractive index n of the N-type doped polysilicon layer before the passivation treatment is greater than or equal to 0.3 and less than or equal to 1.1 and beneficial effects when the ratio of the extinction coefficient k of the N-type doped polysilicon layer after the passivation treatment to the extinction coefficient k of the N-type doped polysilicon layer before the passivation treatment is greater than or equal to 1.9 and less than or equal to 2.1 are similar to the beneficial effects when the ratio of the thickness of the N-type doped polysilicon layer after the passivation treatment to the thickness of the N-type doped polysilicon layer before the passivation treatment is greater than or equal to 0.85 and less than or equal to 0.9, and details are not described herein.

For example, after the surface passivation layer is formed, as shown in FIG. 13, positive electrodes 15 located on the side of the P-type doped polysilicon layer 12 facing away from the semiconductor substrate 11 and negative electrodes 16 located on the side of the N-type doped polysilicon layer 13 facing away from the semiconductor substrate 11 may be formed through a process such as screen printing. For depths by which the positive electrodes 15 and the negative electrodes 16 respectively extend into the P-type doped polysilicon layer 12 and the N-type doped polysilicon layer 13 along the thickness direction of the semiconductor substrate 11, reference may be made to the foregoing description.

It should be noted that, as described above, no matter for tests of the extinction coefficients k and the refractive indexes n of the first intrinsic polysilicon layer and the second intrinsic polysilicon layer or tests of the extinction coefficients k and the refractive indexes n of the P-type doped polysilicon layer and the N-type doped polysilicon layer, a side of a to-be-tested film layer facing away from the semiconductor substrate needs to be exposed to the outside, and an extinction coefficient k and a refractive index n of the to-be-tested film layer are then obtained through a test instrument such as an ellipsometer under the same test conditions, to improve the accuracy of a test result.

An embodiment of the present application further provides a specific example, to describe a process of manufacturing a solar cell in detail by using manufacturing of a back contact solar cell as an example:

### Example 1

In a first step, cleaned and polished crystalline silicon wafers were placed on a quartz boat in sequence, and the quartz boat filled with the crystalline silicon wafers was transported into an inner furnace cavity at a uniform speed from the bottom of a reaction furnace. Each crystalline silicon wafer includes a first surface and a second surface that are arranged opposite to each other.

In a second step, temperatures in the inner furnace cavity and an outer furnace cavity were raised to 607±5°C, and oxygen was introduced into the inner furnace cavity to oxidize the surface of each crystalline silicon wafer, to at least form a first interface passivation layer on a first surface of the crystalline silicon wafer. An oxidation time is 15 min, and pressure in the inner furnace cavity and pressure in the outer furnace cavity are kept at 300±50 mTorr.

In a third step, the temperatures in the inner furnace cavity and the outer furnace cavity were stabilized at 572±5°C, and SiH₄ was introduced into the inner furnace cavity, to form a first intrinsic polysilicon layer on the first interface passivation layer, so as to obtain a sample A. A deposition time of a polysilicon thin film is 155 min, and the pressure in the inner furnace cavity and the pressure in the outer furnace cavity are kept at 300±50 mTorr.

In a fourth step, a boat loaded with the sample A was placed into a diffusion furnace tube, where a temperature in the furnace tube is 800°C.

In a fifth step, a boron source/oxygen/nitrogen was introduced for diffusion, where pressure in the furnace tube ranges from 100 mbar to 200 mbar, and the temperature ranges from 860°C to 870°C.

In a sixth step, nitrogen was introduced to implement anaerobic propulsion, to form the first intrinsic polysilicon layer into a P-type doped polysilicon layer. A temperature ranges from 910°C to 920°C. Then, large oxygen and small oxygen were introduced simultaneously, to raise the temperature in the furnace tube to 930°C and increase the pressure in the furnace tube to 300 mbar to 500 mbar, so as to perform an oxidation process. Introduction of the large oxygen was stopped, to cool the furnace tube, and the boat was removed, to obtain a sample B.

In a seventh step, wet processing was performed on the sample B, to remove a part of the P-type doped polysilicon layer and a part of the first interface passivation layer located on a portion of the first surface.

In an eighth step, the quartz boat filled with the sample B on which the wet processing was performed was transported into the inner furnace cavity at a uniform speed from the bottom of the reaction furnace. A second interface passivation layer was then formed on a first surface of the sample B. A temperature is 600±5°C, a time is 7 min, and the pressure in the inner furnace cavity and the pressure in the outer furnace cavity are kept at 300±50 mTorr.

In a ninth step, a second intrinsic polysilicon layer was formed on the second interface passivation layer, to obtain a sample C. A temperature is 580±5°C, a time is 42 min, and the pressure in the inner furnace cavity and the pressure in the outer furnace cavity are kept at 300±50 mTorr.

In a tenth step, a boat loaded with the sample C was placed into a furnace tube, where a temperature in the furnace tube is 800°C.

In an eleventh step, a phosphorus source/oxygen/nitrogen was introduced for diffusion, where pressure in the furnace tube is 650 mbar, and the temperature is 860°C. Then, large oxygen and small oxygen were introduced simultaneously, to raise the temperature in the furnace tube to 865°C and increase the pressure in the furnace tube to 950 mbar, so as to perform an oxidation process to form the second intrinsic polysilicon layer into an N-type doped polysilicon layer. Introduction of the large oxygen was stopped, to cool the furnace tube, and the boat was removed, to obtain a sample D.

In a twelfth step, wet processing was performed on the sample D, to remove a part of the N-type doped polysilicon layer and a part of the second interface passivation layer at least located on a part of the P-type doped polysilicon layer.

In a thirteenth step, the sample D on which the wet processing was performed was placed in a process chamber, to form a vacuum constant-temperature environment in the process chamber, where a target temperature ranges from 400°C to 450°C.

In a fourteenth step, H₂O vapor was introduced into the process chamber, to form a passivation interface on a surface of SiO₂ through deposition.

In a fifteenth step, TMA and H₂O vapor was introduced into the process chamber alternately, to grow a highly-passivated Al₂O₃ thin film; and vacuum was broken through purging to complete the process, to obtain a sample E.

**Table 1 Related parameters of the first intrinsic polysilicon layer and the P-type doped polysilicon layer**

| | First intrinsic polysilicon layer | | P-type doped polysilicon layer in the sample B | | P-type doped polysilicon layer in the sample E | | |
|---|---|---|---|---|---|---|---|
| | n | k | n | k | n | k | Film thickness |
| 1 | 3.945 | 0.24 | 3.934 | 0.316 | 3.951 | 0.334 | 256.7 |
| 2 | 3.945 | 0.24 | 3.933 | 0.303 | 3.95 | 0.318 | 259.1 |
| 3 | 3.945 | 0.24 | 3.933 | 0.316 | 3.948 | 0.307 | 260.0 |
| 4 | 3.946 | 0.24 | 3.933 | 0.315 | 3.949 | 0.325 | 257.3 |
| 5 | 3.944 | 0.24 | 3.933 | 0.317 | 3.95 | 0.311 | 259.6 |

**Table 2 Related parameters of the second intrinsic polysilicon layer and the N-type doped polysilicon layer**

| | Second intrinsic polysilicon layer | | N-type doped polysilicon layer in the sample D | | N-type doped polysilicon layer in the sample E | | |
|---|---|---|---|---|---|---|---|
| | n | k | n | k | n | k | Film thickness |
| 1 | 3.832 | 0.493 | 3.907 | 0.342 | 3.986 | 0.675 | 203.2 |
| 2 | 3.836 | 0.498 | 3.911 | 0.342 | 3.987 | 0.671 | 201.8 |
| 3 | 3.825 | 0.491 | 3.904 | 0.341 | 3.988 | 0.657 | 201.8 |
| 4 | 3.826 | 0.494 | 3.901 | 0.340 | 3.985 | 0.683 | 203.6 |
| 5 | 3.827 | 0.509 | 3.905 | 0.341 | 3.987 | 0.663 | 203.2 |

As can be seen from data shown in Table 1, an extinction coefficient k of the P-type doped polysilicon layer in the sample B is less than an extinction coefficient k of the N-type doped polysilicon layer in the sample E, and an extinction coefficient k of the P-type doped polysilicon layer in the sample E is less than an extinction coefficient k of the N-type doped polysilicon layer in the sample E, so that the manufactured positive electrodes are prevented from penetrating the P-type doped polysilicon layer, thereby improving a matching degree between the P-type doped polysilicon layer and the electrode slurry corresponding to the positive electrodes, ensuring that the P-type doped polysilicon layer has a relatively high field passivation effect, and reducing a carrier recombination rate on a back surface. This embodiment of the present application only shows a specific example of the manufacturing method in a case that the extinction coefficient k of the P-type doped polysilicon layer and the extinction coefficient k of the N-type doped polysilicon layer included in the solar cell are the data in the table, and does not represent that the extinction coefficient k of the P-type doped polysilicon layer and the extinction coefficient k of the N-type doped polysilicon layer included in the solar cell are only the specific values in the table, and also does not represent that the solar cell provided in the embodiments of the present application may only be manufactured by using the foregoing manufacturing parameters. Corresponding manufacturing conditions when the extinction coefficient k of the P-type doped polysilicon layer and the extinction coefficient k of the N-type doped polysilicon layer included in the solar cell are other proper values may be properly adjusted according to the foregoing example. For example, the extinction coefficient k and the film layer density of the doped polysilicon layer formed based on the intrinsic polysilicon layer may be adjusted by adjusting the formation time and/or the formation temperature of the intrinsic polysilicon layer. Specifically, within a specific range, a longer formation time and a lower formation temperature corresponding to the intrinsic polysilicon layer indicates a smaller extinction coefficient k and a denser film layer of the doped polysilicon layer formed based on the intrinsic polysilicon layer.

According to a fourth aspect, an embodiment of the present application provides a photovoltaic module. The photovoltaic module includes the solar cell according to the first aspect and various implementations of the first aspect.

For beneficial effects of the fourth aspect and various implementations of the fourth aspect in the embodiments of the present application, reference may be made to the analysis of the beneficial effects of the first aspect and various implementations of the first aspect, and details are not described herein.

In the foregoing description, technical details such as composition and etching of each layer are not described in detail. However, a person skilled in the art should understand that a layer, a region, and the like of a required shape may be formed through various technical means. In addition, to form the same structure, a person skilled in the art may further design a method that is not exactly the same as the method described above. In addition, although the embodiments are separately described above, this does not mean that the measures in the embodiments cannot be advantageously used in combination.

The embodiments of the present disclosure are described above. However, the embodiments are merely for illustrative purposes and are not intended to limit a scope of the present disclosure. The scope of the present disclosure is defined by the appended claims and equivalents thereof. A person skilled in the art may make various substitutes and modifications without departing from the scope of the present disclosure, and the substitutes and modifications shall fall within the scope of the present disclosure.

## Claims

1. A solar cell, comprising:
a semiconductor substrate, comprising a first region and a second region, wherein the first region and the second region are located on a same surface of the semiconductor substrate, or the first region and the second region are respectively located on two opposite surfaces of the semiconductor substrate;
a P-type doped polysilicon layer, formed at least on the first region; and
an N-type doped polysilicon layer, formed at least on the second region, wherein at least a portion of the N-type doped polysilicon layer is spaced apart from at least a portion of the P-type doped polysilicon layer;
wherein a ratio of a refractive index n of the N-type doped polysilicon layer to a refractive index n of the P-type doped polysilicon layer is greater than or equal to 0.9 and less than or equal to 1. 1.

2. The solar cell according to claim 1, wherein an absolute value of a difference value between the refractive index n of the P-type doped polysilicon layer and the refractive index n of the N-type doped polysilicon layer is greater than or equal to 0 and less than or equal to 0.1.

3. The solar cell according to claim 1, wherein an extinction coefficient k of the N-type doped polysilicon layer is greater than an extinction coefficient k of the P-type doped polysilicon layer.

4. The solar cell according to claim 1, wherein the solar cell further comprises a surface passivation layer, wherein the surface passivation layer covers at least a side of the P-type doped polysilicon layer facing away from the semiconductor substrate and a side of the N-type doped polysilicon layer facing away from the semiconductor substrate,
wherein:
a ratio of an extinction coefficient k of the N-type doped polysilicon layer to an extinction coefficient k of the P-type doped polysilicon layer is greater than or equal to 1.5 and less than or equal to 2.5; and/or a difference value between the extinction coefficient k of the N-type doped polysilicon layer and the extinction coefficient k of the P-type doped polysilicon layer is greater than or equal to 0.2 and less than or equal to 0.5.

5. The solar cell according to claim 1, wherein the solar cell further comprises positive electrodes that are in contact with the P-type doped polysilicon layer and negative electrodes that are in contact with the N-type doped polysilicon layer,
wherein along a thickness direction of the semiconductor substrate, a depth by which at least a part of the positive electrodes extend into the P-type doped polysilicon layer is greater than or equal to a depth by which at least a part of the negative electrodes extend into the N-type doped polysilicon layer.

6. The solar cell according to claim 1, wherein the solar cell further comprises positive electrodes that are in ohmic contact with the P-type doped polysilicon layer and negative electrodes that are in ohmic contact with the N-type doped polysilicon layer,
wherein, along a thickness direction of the semiconductor substrate, a depth by which at least a part of the positive electrodes extend into the P-type doped polysilicon layer is greater than or equal to 80 nm and less than or equal to 100 nm; and/or along the thickness direction of the semiconductor substrate, a depth by which at least a part of the negative electrodes extend into the N-type doped polysilicon layer is greater than or equal to 50 nm and less than or equal to 80 nm.

7. The solar cell according to any one of claims 1 to 6, wherein the solar cell further comprises:
a first tunneling passivation layer, and the first tunneling passivation layer is located between the P-type doped polysilicon layer and the semiconductor substrate; and/or
a second tunneling passivation layer, wherein at least a portion of the second tunneling passivation layer is between the N-type doped polysilicon layer and the semiconductor substrate; and/or
the solar cell is a back contact solar cell.

8. A manufacturing method of a solar cell, comprising:
providing a semiconductor substrate, wherein the semiconductor substrate comprises a first region and a second region, wherein and the first region and the second region are located on a same surface of the semiconductor substrate, or the first region and the second region are respectively located on two opposite surfaces of the semiconductor substrate;
forming a P-type doped polysilicon layer at least on the first region; and
forming an N-type doped polysilicon layer at least on the second region, wherein at least a portion of the N-type doped polysilicon layer is spaced apart from at least a portion of the P-type doped polysilicon layer,
wherein:
a ratio of a refractive index n of the N-type doped polysilicon layer to a refractive index n of the P-type doped polysilicon layer is greater than or equal to 0.9 and less than or equal to 1.1; and/or an absolute value of a difference value between the refractive index n of the P-type doped polysilicon layer and the refractive index n of the N-type doped polysilicon layer is greater than or equal to 0 and less than or equal to 0.1.

9. The manufacturing method of a solar cell according to claim 8, wherein in a case that the first region and the second region are located on the same surface of the semiconductor substrate:
the forming a P-type doped polysilicon layer at least on the first region comprises: forming a first intrinsic polysilicon layer covering the first region and the second region; performing diffusion treatment on the first intrinsic polysilicon layer, to form the first intrinsic polysilicon layer into the P-type doped polysilicon layer; and selectively removing a part of the P-type doped polysilicon layer located on at least a part of the second region; and the forming an N-type doped polysilicon layer at least on the second region comprises: forming a second intrinsic polysilicon layer at least covering the P-type doped polysilicon layer and the second region; performing diffusion treatment on the second intrinsic polysilicon layer, to form the second intrinsic polysilicon layer into the N-type doped polysilicon layer; and selectively removing a part of the N-type doped polysilicon layer located on at least a part of the P-type doped polysilicon layer; or
the forming an N-type doped polysilicon layer at least on the second region comprises: forming a second intrinsic polysilicon layer covering the first region and the second region; performing diffusion treatment on the second intrinsic polysilicon layer, to form the second intrinsic polysilicon layer into the N-type doped polysilicon layer; and selectively removing a part of the N-type doped polysilicon layer located on at least a part of the first region; and the forming a P-type doped polysilicon layer at least on the first region comprises: forming a first intrinsic polysilicon layer at least covering the N-type doped polysilicon layer and the first region; performing diffusion treatment on the first intrinsic polysilicon layer, to form the first intrinsic polysilicon layer into the P-type doped polysilicon layer; and selectively removing a part of the P-type doped polysilicon layer located on at least a part of the N-type doped polysilicon layer.

10. The manufacturing method of a solar cell according to claim 8, wherein in a case that the first region and the second region are respectively located on two opposite surfaces of the semiconductor substrate:
the forming a P-type doped polysilicon layer at least on the first region comprises: forming a first intrinsic polysilicon layer at least covering the first region; and performing diffusion treatment on the first intrinsic polysilicon layer, to form the first intrinsic polysilicon layer into the P-type doped polysilicon layer; and
the forming an N-type doped polysilicon layer at least on the second region comprises: forming a second intrinsic polysilicon layer at least covering the second region; and performing diffusion treatment on the second intrinsic polysilicon layer, to form the second intrinsic polysilicon layer into the N-type doped polysilicon layer.

11. The manufacturing method of a solar cell according to claim 9 or 10, wherein an extinction coefficient k of the first intrinsic polysilicon layer is less than an extinction coefficient k of the P-type doped polysilicon layer; and/or
a refractive index n of the first intrinsic polysilicon layer is greater than or equal to a refractive index n of the P-type doped polysilicon layer.

12. The manufacturing method of a solar cell according to claim 9 or 10, wherein a refractive index n of the second intrinsic polysilicon layer is less than a refractive index n of the N-type doped polysilicon layer; and/or
an extinction coefficient k of the second intrinsic polysilicon layer is greater than an extinction coefficient k of the N-type doped polysilicon layer.

13. The manufacturing method of a solar cell according to claim 9 or 10, wherein a formation temperature of the second intrinsic polysilicon layer is greater than a formation temperature of the first intrinsic polysilicon layer; and/or
a formation time of the second intrinsic polysilicon layer is less than a formation time of the first intrinsic polysilicon layer; and/or
a temperature of a diffusion treatment on the first intrinsic polysilicon layer is greater than a temperature of a diffusion treatment on the second intrinsic polysilicon layer.

14. The manufacturing method of a solar cell according to claim 9 or 10, wherein after the forming a P-type doped polysilicon layer at least on the first region and the forming an N-type doped polysilicon layer at least on the second region, the manufacturing method of a solar cell further comprises:
performing passivation treatment at least on a side of the P-type doped polysilicon layer facing away from the semiconductor substrate and a side of N-type doped polysilicon layer facing away from the semiconductor substrate, to form a surface passivation layer at least covering the side of the P-type doped polysilicon layer facing away from the semiconductor substrate and the side of the N-type doped polysilicon layer facing away from the semiconductor substrate, wherein after the passivation treatment, a ratio of an extinction coefficient k of the N-type doped polysilicon layer to an extinction coefficient k of the P-type doped polysilicon layer is greater than or equal to 1.5 and less than or equal to 2.5.

15. A photovoltaic module, comprising the solar cell according to any one of claims 1 to 7.
